(19) Europäisches Patentamt
European Patent Office
Office européen des brevets

(11) **EP 4 179 578 B1**

(12) **EUROPÄISCHE PATENTSCHRIFT**

(45) Veröffentlichungstag und Bekanntmachung des Hinweises auf die Patenterteilung:
**21.08.2024   Patentblatt 2024/34**

(21) Anmeldenummer: **21733418.4**

(22) Anmeldetag: **11.06.2021**

(51) Internationale Patentklassifikation (IPC):
**H01L 31/054** (2014.01)       **B32B 17/10** (2006.01)

(52) Gemeinsame Patentklassifikation (CPC):
**H01L 31/054; B32B 17/10; B32B 27/08; B32B 27/306; B32B 27/34; B32B 27/36; B32B 27/40;** B32B 2274/00; B32B 2307/416; B32B 2419/00; Y02E 10/52

(86) Internationale Anmeldenummer:
**PCT/EP2021/065817**

(87) Internationale Veröffentlichungsnummer:
**WO 2022/008165 (13.01.2022 Gazette 2022/02)**

(54) **FOLIENVERBUND ZUM ERZEUGEN EINES REFLEXIONSEFFEKTS, GEBÄUDEVERKLEIDUNGSELEMENT, SOLARGLASVERBUND**

FILM COMPOSITE FOR PRODUCING A REFLECTION EFFECT, BUILDING CLADDING ELEMENT, AND SOLAR GLASS COMPOSITE

COMPOSITE DE FILM POUR PRODUIRE UN EFFET RÉFLÉCHISSANT, ÉLÉMENT DE REVÊTEMENT DE BÂTIMENT ET COMPOSITE DE VERRE SOLAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.07.2020   DE 102020118035**

(43) Veröffentlichungstag der Anmeldung:
**17.05.2023   Patentblatt 2023/20**

(73) Patentinhaber: **SEEN AG**
**9014 St. Gallen (CH)**

(72) Erfinder: **SEIDLER, Rouven**
**3367 THÖRIGEN (CH)**

(74) Vertreter: **Eisenführ Speiser**
**Patentanwälte Rechtsanwälte PartGmbB**
**Stralauer Platz 34**
**10243 Berlin (DE)**

(56) Entgegenhaltungen:
**WO-A1-2019/038288     US-B2- 9 281 186**

## Beschreibung

Die Erfindung betrifft ein Folienverbund für ein Gebäudeverkleidungselement oder einen Solarglasverbund zum Erzeugen eines Reflexionseffekts gemäß dem Oberbegriff des Anspruchs 1.

Die Erfindung betrifft weiter ein Gebäudeverkleidungselement gemäß dem Anspruch 14 und einen Solarglasverbund gemäß dem Anspruch 15.

Solarmodule und insbesondere Photovoltaikmodule haben aufgrund ihrer energetischen Vorteile einen größer werdenden Einfluss auf die Gestaltung von Gebäuden.

In US 9,281,186 B2 ist ein farbiges photovoltaisches Modul und Verfahren zu seiner Herstellung beschrieben, wobei das Modul umfasst: eine photovoltaische Zelle und einen das Erscheinungsbild modifizierenden Film, ein Verkapselungsmittel oder eine Verglasung, wobei der das Erscheinungsbild modifizierende Film, das Verkapselungsmittel oder die Verglasung umfasst: einen Lichtsteuerungsfilm; ein grafisches Material; einen Leuchtstoff; einen dichroitischen Film; Nanopartikel; Mikropunkte; Metallflocken; Farbe; ein additives Material für den 3D-Druck.

Beispielsweise in WO 2013/040 617 A1 sind grundsätzlich Folienverbunde im Zusammenhang mit Solarmodulen bzw. Photovoltaikmodulen beschrieben. Häufig ist es jedoch erstrebenswert, insbesondere wegen ästhetischer Gründe, Solarmodule visuell zu kaschieren, das heißt den visuellen Eindruck eines Solarmoduls zu vermindern oder vollständig zu eliminieren, insbesondere die Konturen und/oder Oberflächenstrukturen von dessen Moduloberfläche in der Wahrnehmung eines Betrachters aufzulösen.

Herkömmliche Ansätze zum visuellen Kaschieren liegen insbesondere in dem Bedrucken von Solarmodulen oder dem Anordnen von bedrucktem Glas auf ein Solarmodul. Beispielsweise wird bei dem Produkt *Swisspanel Solar* ein mittels Digitaldruck bedrucktes Floatglas auf ein Photovoltaikmodul angeordnet (https://www.qlastroesch.ch/qlas/954-swisspanel-solar.html).

Problematisch bei auf Bedruckung basierenden Ansätzen ist jedoch, dass für ein ausreichendes visuelles Kaschieren eine relativ hohe Flächenbedeckung erreicht werden muss, was sich generell negativ auf eine Energieausbeute des Solarmoduls auswirkt. Auch können mittels bedruckter Oberflächen in der Regel keine weitergehenden Effekte, insbesondere keine Reflexionseffekte erzeugt werden.

Flächenelemente und insbesondere Folien zum Erzeugen eines Reflexionseffekts sind grundsätzlich vorteilhaft zum Erzeugen optisch ansprechender Flächen. Derartige Elemente sind insbesondere ausgebildet, einfallendes Licht zu reflektieren, sodass sich für einen Betrachter ein visueller Effekt ergibt, der in Abhängigkeit seines Standpunkts variieren kann.

Verbundglas mit Pailletten zum Erzeugen eines Reflexionseffekts ist aus der WO 2019/038288 A1 bekannt. Die WO 2019/038288 A1 beschreibt ein Verbundglas umfassend eine erste und eine zweite Glasscheibe sowie einen zwischen der ersten und zweiten Glasscheibe angeordneten und mit diesen verbundenen Laminierfolienverbund mit einer ersten und einer zweiten Laminierfolie. Bei dem dort beschriebenen Verbundglas ist eine Vielzahl von Pailletten mit einer zu einer Fassadeninnenseite vorgesehenen ersten lichtabsorbierenden Oberfläche zwischen der ersten und zweiten Laminierfolie angeordnet, wobei die Pailletten mit der zu der Fassadeninnenseite vorgesehenen lichtabsorbierenden Oberfläche der ersten Laminierfolie zugewandt sind und derart voneinander beabstandet angeordnet sind, dass das Verbundglas auf Seiten der lichtabsorbierenden Oberfläche der Pailletten betrachtet durchsichtig erscheint.

Aus WO 2019/057327 A1 ist ein plättchenförmiges Pigment mit einem Schichtaufbau bekannt, der in der Reihenfolge die folgenden Schichten umfasst - optional ein Trägersubstrat; - eine transparente Prägelackschicht mit einer eingeprägten Reliefstruktur: - eine der Reliefstruktur folgende, eine reflektierende Mikrostruktur bildende reflexionserhöhende Beschichtung, wobei die reflektierende Mikrostruktur in Form eines Mosaiks aus einer Vielzahl reflektierender Mosaikelemente vorliegt und die reflektierenden Mosaikelemente das einfallende Licht mit Bezug auf die Ebene des Plättchens nicht in die Richtung des Spiegelreflexes, sondern in eine davon abweichende Raumrichtung reflektieren und jeweils eine laterale Abmessung, die größer ist als 2 $\mu$m ist, aufweisen.

Die aus der WO 2019/057327 A1 bekannten plättchenförmigen Pigmente sind insbesondere für den Einsatz als Sicherheitsmerkmal im Wertdokumentbereich vorgesehen. So können die farbkippenden Beschichtungen alternativ und/oder zusätzlich zu dekorativen Zwecken eingesetzt werden, z.B. als gedrucktes Dekorelement auf Druckerzeugnissen oder als farbkippende Lackierung im Bereich von Automobilen, Smartphones oder dergleichen. Auch dabei handelt es sich um eine, eine reflektierende Mikrostruktur bildende, reflexionserhöhende Beschichtung.

Derartige Ansätze zum Erzeugen eines Reflexionseffekts sind verbesserungswürdig, insbesondere im Zusammenhang mit Fassaden- oder Gebäudeverkleidungselementen. Besonders im Zusammenhang mit einem Solarmodul ist es wünschenswert, einen Reflexionseffekt zu erzeugen, ohne jedoch dabei die Funktion einer Solarmodulanordnung zu stark zu beeinträchtigen. Insbesondere soll eine Energieausbeute eines Solarmoduls nicht zu stark beeinträchtigt werden.

An dieser Stelle setzt die Erfindung an, deren Aufgabe es ist, einen verbesserten Folienverbund anzugeben, der mindestens eines der eingangs genannten Probleme verbessert. Insbesondere ist es die Aufgabe der Erfindung, ein Erzeugen eines Reflexionseffekts zu ermöglichen, ohne die Funktion einer Solarmodulanordnung zu stark zu beeinträchtigen. Es wurde insbesondere erkannt, dass vollreflektierende Mittel - wie in der eingangs genannten WO 2019/038288 A1 beschrieben - zum Erzeugen eines Reflexionseffekts für einen Einsatz mit Solarmodulen nicht oder allenfalls nur bedingt geeignet sind, da sie die Funktion eines Solarmoduls, insbesondere hinsichtlich der Energieausbeute, zu stark beeinträchtigen.

Mit bestehenden Ansätzen, insbesondere dem in WO 2019/038288 A1 beschriebenen Ansatz, wäre ein Verbessern der Lichtausbeute des Solarmoduls, allenfalls über ein signifikantes Verringern des Flächenbedeckungsgrades möglich, welches aber wiederum einen ungewünschten, vermindernden Einfluss auf die Erzeugung des Reflexionseffekts hätte, insbesondere kein zum visuellen Kaschieren ausreichender Reflexionseffekt erzeugt werden kann.

Insbesondere soll dem Gestalter bzw. Architekt mit verbesserten Folienverbund zur Erzeugung eines gewünschten Reflexionseffekts ein weiterer Freiheitsgrad bei der Gestaltung der Fassade ermöglicht werden.

Die Aufgabe, den Folienverbund betreffend, wird in einem ersten Aspekt der Erfindung mit einem Folienverbund des Anspruchs 1 gelöst.

Die Erfindung geht aus von einem Folienverbund ausgebildet zur Anordnung in einem Gebäudeverkleidungselement oder einem Solarglasverbund, wobei der Folienverbund aufweist:

- eine Deck-Laminierfolie,

- eine Träger-Laminierfolie,

- eine zwischen der Träger-Laminierfolie und der Deck-Laminierfolie angeordnete Anzahl von Pailletten.

Erfindungsgemäß ist bei dem Folienverbund vorgesehen, dass

- die Paillette eine lichtdurchlässige Paillettenträgerfolie aufweist, die eine teilreflektierende, insbesondere metallische, Beschichtung aufweist, derart, dass ein Teil einfallender Lichtstrahlung als transmittierte Lichtstrahlung transmittiert und ein Teil einfallender Lichtstrahlung als reflektierte Lichtstrahlung reflektiert wird, wobei

- die teilreflektierende Beschichtung eine optische Dichte aufweist und die optische Dichte zwischen 0,1 und 0,7 liegt, und

- die teilreflektierende Beschichtung der Paillette ausgebildet ist, mittels der reflektierten Lichtstrahlung einen Reflexionseffekt zu erzeugen, und

- die Pailletten im Folienverbund eine Fläche bedecken, sodass ein Flächenbedeckungsgrad kleiner als 0,7 ist.

Insbesondere liegt die optische Dichte zwischen 0,2 und 0,5.

Insbesondere ist der Reflexionseffekt wahrnehmbar, insbesondere von einem Betrachter im Einbauzustand von außen wahrnehmbar.

Bevorzugt ist der Flächenbedeckungsgrad kleiner als 0,5, besonders bevorzugt kleiner 0,3.

Die Deck-Laminierfolie und/oder die Träger-Laminierfolie sind insbesondere lichtdurchlässig ausgebildet, bevorzugt im laminierten Zustand transparent ausgebildet. "Im laminierten Zustand" bedeutet insbesondere, dass die Deck-Laminierfolie und/oder die Träger-Laminierfolie in einem Laminierverfahren zu einem Folienverbund zusammengefügt sind.

Die Paillettenträgerfolie ist insbesondere transparent ausgebildet.

Die optische Dichte ist im Sinne einer Extinktion als die wahrnehmungsgerecht logarithmisch formulierte Opazität zu verstehen und damit als ein Maß für die Abschwächung einer Lichtstrahlung nach Durchqueren eines Mediums. Die optische Dichte ist im Allgemeinen abhängig von der Wellenlänge $\lambda$ der Strahlung. Im vorliegenden Fall ist die optische Dichte unabhängig von der Wellenlänge im Bereich des sichtbaren Lichts zwischen 0,1 und 0,7. Bevorzugt ist jedenfalls ein Mittelwert der optischen Dichte über das Spektrum des sichtbaren Lichts, insbesondere einen Wellenlängenbereich von 400 nm bis 750 nm, oder alternativ ein Einzelwert für eine charakteristische Wellenlänge innerhalb des Spektrum des sichtbaren Lichts, insbesondere bei 550 nm.

Der Flächenbedeckungsgrad beschreibt vorliegend das Verhältnis von der von Pailletten bedeckten Fläche im Folienverbund zu einer gesamten Folienfläche, wobei die Folienfläche als ausreichend große Einheitsfläche des Folienverbundes zu verstehen ist. Insofern ist der Flächenbedeckungsgrad also ein Maß für eine durchschnittliche Flächenbedeckung einer ausreichend großen Zahl von Pailletten im Folienverbund für eine bestimmte Fläche des Folienverbundes. Diese bestimmte Fläche des Folienverbundes ist entsprechend für die Flächenbedeckung als durchschnittliches Maß ausreichend groß gewählt, z.B. eine Folienfläche des Folienverbundes für ein Gebäudeverkleidungselement oder Solarmodul oder dergleichen Einheit.

Der Flächenbedeckungsgrad kann folglich über die Anordnung der einzelnen Pailletten, insbesondere deren Abstand zueinander, sowie die Größe der einzelnen Pailletten, insbesondere deren Durchmesser, eingestellt werden. Insbesondere sind die Pailletten ausgebildet und im Folienverbund so angeordnet, dass der Flächenbedeckungsgrad kleiner als 0,7, bevorzugt kleiner 0,5, besonders bevorzugt kleiner 0,3 ist.

Die Erfindung geht aus von der Überlegung, dass durch eine Solarmodulanordnung Energie mittels einfallender Lichtstrahlung gewonnen werden kann. Insbesondere aus gestalterischer Sicht gilt es jedoch häufig, die visuelle Erscheinung eines Solarmoduls zu verringern oder zu eliminieren.

Die Erfindung schließt dabei die Überlegung ein, dass ein Folienverbund mit einer Anzahl an Pailletten vorteilhaft in einer Solarmodulanordnung eingesetzt werden kann.

Im Unterschied zu üblichen flächigen Strukturen zum Abdecken von Solarmodulen, insbesondere Gewebe, Lochfolien, Bedruckungen und/oder Lackschichten, hat die Erfindung erkannt, dass der Einsatz einer Anzahl von Pailletten auf einer Laminierfolie den Vorteil einer größeren gestalterischen Freiheit bietet. Dies hat insbesondere den Vorteil, dass durch eine Positionierung der Pailletten auf der Laminierfolie der Abstand zwischen einzelnen Pailletten und/oder ein Muster von Pailletten frei - und insbesondere gezielt zum Einstellen eines gewünschten optischen Effekts, nämlich den insbesondere wahrnehmbaren, erfindungsgemäßen Reflexionseffekt - gewählt werden kann.

Es wird insbesondere durch das punktuelle Aufbringen von Pailletten im Unterschied zu vollflächigen Strukturen, insbesondere Gewebe, Lochfolien und dergleichen Strukturen, die Haftung des Verbundes, das heißt der einzelnen Laminierschichten untereinander, verbessert.

Es wird erfindungsgemäß durch die teilreflektierende Eigenschaft der- insbesondere als makroskopische optische Elemente ausgebildete - Pailletten und deren flächige Anordnung, ein insbesondere wahrnehmbarer, Reflexionseffekt erzeugt. Als Pailletten sind im Rahmen der Erfindung also im Wesentlichen flache und auf einem Folienverbund anordnenbare und ausrichtbare makroskopische Objekte zu verstehen, die, insbesondere zum Erzeugen von optischen Mustern wahrnehmbarer Reflexionseffekte, voneinander beabstandet in einem Folienverbund anzuordnen sind.

Vorteilhafte Weiterbildungen der Erfindung sind den Unteransprüchen zu entnehmen und geben im Einzelnen vorteilhafte Möglichkeiten an, das oben erläuterte Konzept im Rahmen der Aufgabenstellung sowie hinsichtlich weiterer Vorteile zu realisieren.

Pailletten können insbesondere einen Paillettendurchmesser oder eine Paillettenbreite oder eine Paillettenlänge zwischen 1 mm und 39 mm aufweisen. Pailletten mit einer streifenförmigen Flächenform können eine Paillettenbreite zwischen 1 mm und 300 mm aufweisen und eine Paillettenlänge aufweisen, die sich über einen größeren Bereich, insbesondere über einen gesamten Folienverbund und/oder Solarglasverbund oder Sonnenschutzglasverbund, erstreckt. In Weiterbildungen aufweisend Pailletten mit einer streifenförmigen Flächenform können einzelne oder mehrere oder sämtliche Pailletten eine oder mehrere Unterbrechungen aufweisen, wobei eine Unterbrechung eine Paillette in zwei Teile mit jeweils einer geringeren Paillettenlänge teilt.

Im Unterschied zu einer bloßen Spiegelung führt ein Reflexionseffekt zu einerwahrgenommenen, abstrakten Verfremdung eines Bildes, insbesondere durch eine laterale Unterbrechung der Reflexionsfläche, eine Verzerrung, eine Krümmung, eine Färbung und/oder dergleichen Veränderung des einfallenden Lichts. Ein Reflexionseffekt ist somit eine von einem Betrachter wahrgenommene, verfremdete Wiedergabe des einfallenden Lichts, der durch die über die teilreflektierenden Pailletten reflektierte Lichtstrahlung erzeugt wird.

Insbesondere kann sich der Reflexionseffekt vorteilhaft in Abhängigkeit der Perspektive und insbesondere des Standpunkts des Betrachters in dessen Wahrnehmung ändern. Dies führt vorteilhaft zu einer lebendigen Erscheinung - insbesondere zu einem Schimmern und/oder einem Changieren - der Oberfläche des Folienverbundes. Durch den mittels Pailletten hervorgerufenen Reflexionseffekt können daher optisch ansprechende, "lebendige" Gebäudeoberflächen erzeugt werden. Dies ist insbesondere vorteilhaft gegenüber Ansätzen zu sehen, in denen Schichtbestandteile in Form von - nicht orientierten - Partikeln beigemischt werden oder auch gegenüber den bereits genannten Geweben, Lochfolien, Bedruckungen und/oder Lackschichten. In derartigen, konventionellen Ansätzen resultiert im Unterschied zum Konzept der Erfindung in der Regel lediglich eine matte oder eine nicht in Abhängigkeit des Standpunkts des Betrachters ändernde oder eine nicht verfremdete Oberfläche. Insbesondere im Unterschied zu Ansätzen mit nicht orientierten Partikeln weisen die Pailletten des erfindungsgemäßen Folienverbundes - unabhängig von etwaigen Wölbungen oder Mikrostrukturierungen einzelner Pailletten - eine gemeinsame Ausrichtung auf, indem sie in einer gemeinsamen Ebene zwischen einer Träger-Laminierfolie und einer Deck-Laminierfolie im Wesentlichen parallel zu dem Folienverbund angeordnet sind.

Die Pailletten werden durch ihre Integration im laminierten Folienverbund weiterhin vorteilhaft vor äußeren Umgebungseinflüssen geschützt.

Eine Weiterbildung schließt die Erkenntnis ein, dass ein erfindungsgemäßer Folienverbund mit einer Anzahl an Pailletten besonders vorteilhaft mit einem lichttransmissionsmindernden Flächenelement kombiniert werden kann, weil zum einen ein optisch ansprechender Reflexionseffekt erzeugt werden kann, der die Wahrnehmung eines Betrachters von der naturgemäß dunklen Oberfläche des Solarmoduls ablenkt und darüber hinaus der Gebäudeoberfläche eine lebendige Erscheinung verleiht.

Dies schließt die Erkenntnis ein, dass zum Erzeugen des gewünschten Reflexionseffekts keine vollständig reflektierenden Pailletten benötigt werden, sondern teilreflektierende Pailletten bereits ausreichen, um einen ausreichenden Reflexionseffekt zu erzeugen. Die Erzeugung eines ausreichenden Reflexionseffekts bereits mit einem relativ geringen Anteil an reflektierter Lichtstrahlung wird vorteilhaft synergetisch verstärkt durch einen relativ hohen Kontrast zwischen den teilreflektierenden Pailletten und dem dahinter angeordneten, relativ dunklen Solarmodul. Hierdurch wird der Reflexionseffekt für einen Betrachter weiter verstärkt.

Dabei ist die Eigenschaft der Pailletten vorteilhaft, einen Teil der einfallenden Lichtstrahlung als transmittierte Lichtstrahlung durchzulassen und einen Teil der einfallenden Lichtstrahlung als reflektierte Lichtstrahlung zum Erzeugen des Reflexionseffekts zu reflektieren. Der erfindungsgemäße Folienverbund mit den Pailletten ist vorteilhaft geeignet, einen Reflexionseffekt zu erzeugen und gleichzeitig die Funktion der Solarmodulanordnung nicht zu beeinträchtigen. Dies ist insbesondere darauf zurückzuführen, dass über die optische Dichte der Pailletten das Reflexions- und Transmissionsverhalten bedarfsgerecht eingestellt bzw. gewählt werden kann, um einen - insbesondere zum visuellen Kaschieren ausreichenden - Reflexionseffekt wirksam zu erzeugen, gleichzeitig aber noch ausreichend transmittierte Lichtstrahlung zuzulassen, um die Funktion des Solarmoduls möglichst wenig zu beeinträchtigen.

Eine erfindungsgemäße geringe optische Dichte zwischen 0,1 und 0,7 - insbesondere verglichen mit lichtundurchlässigen Mitteln zum visuellen Kaschieren - wirkt sich zugunsten eines höheren Lichteintrags und somit einer höheren Energieausbeute des Solarmoduls aus. Die damit einhergehende Abnahme des reflektierten Anteils des einfallenden Lichts kann hingenommen werden, weil aufgrund eines verbleibenden reflektierten Anteils und insbesondere auch des - durch die dunkle Oberfläche - verstärkten Kontrastes zwischen den Pailletten und der Moduloberfläche ein zum visuellen Kaschieren ausreichender Reflexionseffekt erzeugt werden kann. Die optische Dichte kann insbesondere über die Beschichtungsstärke und über die Wahl des Materials der Beschichtung auf einen gewünschten Wert eingestellt werden.

"Kaschieren des visuellen Eindrucks" oder "visuelles Kaschieren" durch den Folienverbund bedeutet dabei, den visuellen Eindruck des dahinterliegenden Solarmoduls zu vermindern oder vollständig zu eliminieren, insbesondere die Konturen und/oder Oberflächenstrukturen von dessen Moduloberfläche in der Wahrnehmung eines Betrachters aufzulösen, indem ein Reflexionseffekt erzeugt wird, der für einen Außen stehenden Betrachter in den Vordergrund tritt.

Dies führt vorteilhaft dazu, dass - mittels des durch die Pailletten erzeugbaren Reflexionseffekts - das hinter dem Folienverbund angeordnete Solarmodul visuell kaschiert werden kann, weil dessen optischer Eindruck in der Wahrnehmung eines Betrachters vermindert oder sogar eliminiert werden kann, was generell vorteilhaft ist. Der Reflexionseffekt, der erzeugt wird, indem eine oder mehrere Pailletten der Anzahl an Pailletten die einfallende Lichtstrahlung teilweise reflektieren und in Richtung des Betrachters lenken, tritt somit gegenüber dem Solarmodul in den Vordergrund.

Durch einen Folienverbund mit Pailletten mit einer optischen Dichte und/oder einem Flächenbedeckungsgrad in den in Anspruch 1 angegebenen Bereichen wird das visuelle Kaschieren des Solarmoduls verbessert, da schon mit einer relativ geringen Flächenbedeckung der Moduloberfläche und/oder einer relativ geringen optischen Dichte ein für einen Betrachter wahrnehmbarer Reflexionseffekt entsteht. Somit wird ein visuelles Kaschieren und gleichzeitig durch die geringe Flächenbedeckung vorteilhaft eine relativ hohe Energieausbeute des Solarmoduls erreicht. Insbesondere tritt die teilreflektierende Beschichtung der Pailletten - trotz ihrer teilweisen Lichtdurchlässigkeit - im Vergleich zum Rest des Folienverbundes und der dahinterliegenden Oberfläche des Solarmoduls, insbesondere aufgrund des Reflexionseffekts, in der Wahrnehmung eines Betrachters überproportional hervor.

Insbesondere ist die teilreflektierende Beschichtung auf einer, der Deck-Laminierfolie zugewandten, Sichtseite der Paillettenträgerfolie angeordnet.

Insbesondere weist die teilreflektierende Beschichtung eine optische Dichte zwischen 0,1 und 0,5, bevorzugt zwischen 0,2 und 0,5 auf. Eine relativ geringe optische Dichte, insbesondere zwischen 0,2 und 0,5, hat sich insbesondere in Weiterbildungen als vorteilhaft erwiesen, in denen die teilreflektierende Beschichtung Aluminium aufweist oder vollständig aus Aluminium gebildet ist, da Aluminium einen relativ hohen Reflexionsanteil aufweist, was vorteilhaft für die Erzeugung eines Reflexionseffekts ist.

Insbesondere ist vorgesehen, dass eine Träger-Laminierfolienstärke der Träger-Laminierfolie und/oder eine Deck-Laminierfolienstärke der Deck-Laminierfolie zwischen 0,2 mm und 3 mm, bevorzugt zwischen 0,35 mm und 1,7 mm, besonders bevorzugt zwischen 0,7 mm und 0,8 mm liegt.

Die Träger-Laminierfolienstärke und/oder die Deck-Laminierfolienstärke kann, insbesondere bei einer aus Polyvinyl-Butyral (PVB) gebildeten Laminierfolie, zwischen 0,38mm und 1,52 mm, bevorzugt bei 0,76 mm liegen. Die Träger-Laminierfolienstärke und/oder die Deck-Laminierfolienstärke kann, insbesondere bei einer aus thermoplastischem Polyurethan (TPU) gebildeten Laminierfolie, zwischen 0,2 mm und 2,54 mm, bevorzugt bei 0,76 mm liegen.

Durch eine relativ große Träger-Laminierfolienstärke, beispielsweise von mindestens 1 mm, kann eine bessere elektrische Isolierung der Pailletten von dem Solarmodul erreicht werden. Eine elektrische Isolierung kann alternativ oder zusätzlich durch eine entsprechende Gestaltung der Pailletten, insbesondere durch den Einsatz einer Paillettendeckfolie und eine ausreichend hohe Schichtstärke der Paillettenträgerfolie und/oder der Paillettendeckfolie, verbessert werden. Eine verbesserte elektrische Isolierung ist besonders vorteilhaft in Weiterbildungen mit einem Photovoltaikmodul die Kurzschlussfestigkeit verbessert.

Im Rahmen einer bevorzugten Weiterbildung weisen die Pailletten eine Paillettenstärke zwischen 23 μm und 500 μm, bevorzugt zwischen 75 μm und 350 μm, besonders bevorzugt zwischen 100 μm und 250 μm auf.

In einer Weiterbildung weist der Folienverbund eine zwischen der Träger-Laminierfolie und der Anzahl an Pailletten angeordnete Zwischen-Trägerfolie auf.

In einer Weiterbildung weist der Folienverbund, insbesondere zusätzlich zu einer Zwischen-Trägerfolie, eine zwischen der Deck-Laminierfolie und der Anzahl an Pailletten angeordnete Zwischen-Deckfolie auf. Die Zwischen-Trägerfolie und die Zwischen-Deckfolie können mit der dazwischen angeordneten Anzahl an Pailletten als Zwischenprodukt ein Zwischenlaminat bilden.

Die Zwischen-Trägerfolie und/oder die Zwischen-Deckfolie kann insbesondere aus Polyethylenterephthalat (PET) gebildet sein und jeweils eine Stärke von 50-350 μm aufweisen. In Weiterbildungen der Erfindung ohne eine Zwischen-Trägerfolie und ohne eine Zwischen-Deckfolie kann ein hoher Zusammenhalt des Folienverbunds erreicht werden, da die Träger-Laminierfolie und die Deck-Laminierfolie insbesondere nur im Bereich der Pailletten nicht direkt aufeinanderliegen, und den übrigen Bereichen durch das Laminierverfahren verbunden werden.

Im Rahmen einer Weiterbildung ist vorgesehen, dass die Paillette eine Paillettendeckfolie aufweist. Eine Paillettendeckfolie kann insbesondere auf die teilreflektierende Beschichtung der Paillettenträgerfolie, aufgebracht werden und dadurch vorteilhaft eine schützende Schicht bilden. Durch eine Paillettendeckfolie kann die teilreflektierende Beschichtung, insbesondere während des Herstellprozesses, vorteilhaft geschützt werden und die Kurzschlussfestigkeit des Folienverbundes, insbesondere im Zusammenhang mit einem Solarmodul, verbessert werden.

Im Rahmen einer Weiterbildung ist vorgesehen, dass mindestens eine Paillette eine weitere Paillettenträgerfolie mit einer weiteren teilreflektierenden Beschichtung auf der zur Sichtseite gerichteten Seite der weiteren Paillettenträgerfolie aufweist. Mittels einer weiteren Paillettenträgerfolie mit einer weiteren teilreflektierenden Beschichtung können vorteilhaft unterschiedliche Reflexionseffekte, insbesondere mit unterschiedlichen Farben oder Farbspektren, erzeugt werden. Beispielsweise kann eine Beschichtung aus Chrom ausgebildet sein, und die weitere Beschichtung aus Kupfer. Pailletten in Weiterbildungen können auch zusätzlich weitere teilreflektierende Beschichtungen aufweisen.

Im Rahmen einer Weiterbildung ist vorgesehen, dass die teilreflektierende Beschichtung und/oder die weitere teilreflektierende Beschichtung mindestens eines der folgenden Materialen aufweist, insbesondere aus einem der folgenden Materialen gebildet ist: Chrom, Aluminium, Kupfer, Silber, Titannitrid, Aluminium-Kupfer-Legierung, Siliziumdioxid. In einer Weiterbildung weisen verschiedene Pailletten eines Folienverbundes jeweils voneinander unterschiedliche Beschichtungsmaterialen auf. Insbesondere weist eine erste Teilmenge von Pailletten eine Beschichtung aus einem ersten Material, und eine zweite Teilmenge von Pailletten eine Beschichtung aus einem zweiten Material. Auch sind weitere Teilmengen von Pailletten möglich, die eine Beschichtung aus einem weiteren Material aufweisen.

Auf diese Weise können vorteilhaft Muster, insbesondere verschiedene Farben aufweisende Muster, erzeugt werden.

Mittels einer Siliziumdioxid aufweisenden Beschichtung können vorteilhaft Farbwechseleffekte erzeugt werden insbesondere derart, dass sich die Farbe der Paillette in Abhängigkeit des Betrachters ändert. Dieser Farbwechseleffekt kann vorteilhaft synergetisch mit dem Reflexionseffekt zum Erreichen einer lebendigen Erscheinung des Folienverbundes, insbesondere zum Erreichen eines Schimmerns und/oder eines Changierens, zusammenwirken.

Mittels einer Aluminium aufweisenden Beschichtung wird aufgrund der relativ hellen Oberfläche der Beschichtung vorteilhaft eine möglichst geringe farbliche Verfremdung erreicht. Eine möglichst geringe farbliche Verfremdung ist insbesondere vorteilhaft bei Pailletten, die einen Dekorfilm aufweisen, da die Farben des Dekorfilms möglichst wenig verändert werden.

Insbesondere kann die Beschichtung metallisch oder metallisiert ausgebildet sein.

Im Rahmen einer Weiterbildung ist vorgesehen, dass mindestens eine Paillette einen Dekorfilm aufweist. Ein Dekorfilm kann bevorzugt auf der Paillettenträgerfolie, insbesondere auf einer der Beschichtung gegenüberliegenden Seite der Paillettenträgerfolie aufgebracht sein. Ein Dekorfilm kann insbesondere lichtdurchlässig, aber eingefärbt und/oder bedruckt ausgebildet sein. Ein Dekorfilm kann als Folie oder Lackschicht ausgebildet sein und insbesondere eine Färbung und/oder ein Muster aufweisen. Ein Dekorfilm kann insbesondere als bedruckte, lichtdurchlässige Folie ausgebildet sein.

Im Rahmen einer Weiterbildung ist vorgesehen, dass mindestens eine Paillette, insbesondere auf der Paillettenträgerfolie und/oder der weiteren Paillettenträgerfolie, eine dreidimensionale Oberflächenstrukturierung, insbesondere Mikrospiegelanordnung aufweist. Eine Oberflächenstrukturierung weist insbesondere eine Strukturtiefe, das heißt einen normal zur Folienoberfläche gemessenen Abstand zwischen tiefstem und höchstem Punkt der Oberflächenstrukturierung, von einigen Mikrometern, bevorzugt kleiner als 30 μm, besonders bevorzugt kleiner als 10 μm, auf. Insbesondere weisen alle Pailletten eines Folienverbundes eine dreidimensionale Oberflächenstrukturierung auf. Eine Mikrospiegelanordnung kann insbesondere als Fresnel-Optik oder dergleichen Mikrospiegelanordnung ausgebildet sein. Durch eine derartige Oberflächenstrukturierung, insbesondere Mikrospiegelanordnung, können vorteilhaft dreidimensionale Muster mit einer relativ großen wahrgenommenen Tiefenwirkung, beispielsweise von mehreren Millimetern, erzeugt werden, obwohl die tatsächliche Strukturtiefe wesentlich niedriger, beispielsweise nur einige Mikrometer, ist. Auch können mit einer Oberflächenstrukturierung und/oder einer Mikrospiegelanordnung vorteilhaft chromatische Effekte, insbesondere Farbwechseleffekte, für einen Betrachter erzeugt werden.

Im Rahmen einer Weiterbildung kann die Oberfläche der Sichtseite der Paillette und/oder der Paillettenträgerfolie gebogen oder gewölbt, insbesondere konvex oder konkav gewölbt, sein.

Im Rahmen einer Weiterbildung, bei der die dreidimensionale Oberflächenstrukturierung eine Mikrospiegelanordnung ist, ist vorgesehen, dass die Mikrospiegelanordnung als Ersatzoptik eine konkave oder eine konvexe Form ergibt. Ersatzoptik bedeutet insbesondere, dass auf der Paillette bei einfallender Lichtstrahlung eine für einen Betrachter sichtbare dreidimensionale Darstellung erzeugt wird, die einer konkaven oder konvexen Form entspricht. In Weiterbildungen kann die Mikrospiegelanordnung ausgebildet sein, die Darstellung anderer Formen, beispielsweise wellenartige Muster, wiederkehrende geometrische Formen und dergleichen Muster zu erzeugen.

Im Rahmen einer Weiterbildung ist vorgesehen, dass mindestens eine Paillette, insbesondere alle Pailletten, als teilreflektierende Beschichtung eine veränderliche Beschichtung, bevorzugt eine lateral variierende Beschichtung, besonders bevorzugt eine Gradienten-Beschichtung, aufweist. Als lateral variierende Beschichtung ist eine Beschichtung zu verstehen, welche über den Verlauf der Paillettenoberfläche veränderliche Eigenschaften aufweist, beispielsweise über den Verlauf der Paillettenoberfläche die Farbe, das Material, und/oder die Beschichtungsstärke ändert. Insbesondere ist die Beschichtungsstärke der Beschichtung lateral veränderlich, um vorteilhaft in Bereichen der Paillette eine höhere optische Dichte zu erzeugen als in anderen Bereichen. Unter einer Gradienten-Beschichtung ist eine veränderliche Beschichtung zu verstehen, die in stetiger Weise über den Verlauf der Paillettenoberfläche seine Eigenschaft verändert. Insbesondere kann die Beschichtungsstärke in stetiger Weise variieren, beispielsweise im Zentrum einer Paillette einen Maximalwert aufweisen, beispielsweise 20 nm, und von dort in radialer Richtung zum Rand der Paillette stetig abnehmen, beispielsweise auf einen Wert von 10 nm oder 0 nm. Gleichwohl sind auch Weiterbildungen mit stufenförmigen Änderungen möglich. Mittels einer veränderlichen Beschichtung kann innerhalb einer Paillette ein Effekt bei der teilweisen Reflexion der Lichtstrahlung erzeugt werden.

Im Rahmen einer Weiterbildung ist vorgesehen, dass die Träger-Laminierfolie und/oder die Deck-Laminierfolie aus einem Duroplast oder einem Thermoplast hergestellt ist. Insbesondere ist die Träger-Laminierfolie und/oder die Deck-Laminierfolie aus Polyvinyl-Butyral (PVB), Ethylen-Vinylacetat (EVA), thermoplastischen Polyurethan (TPU), Sentryglas ® oder SOLAR ASCE™ hergestellt ist. SOLAR ASCE™ ist eine Marke der Mitsui Chemicals Tohcello. Inc. Die genannten Materialen weisen insbesondere vorteilhafte mechanische und optische Eigenschaften auf und sind insbesondere im ausreichenden Maße beständig gegenüber einfallender UV-Strahlung, reißfest und/oder zähelastisch. Ethylen-Vinylacetat (EVA) hat sich besonders vorteilhaft in Weiterbildungen erwiesen, bei denen das Solarmodul als Photovoltaikmodul ausgebildet ist.

Im Rahmen einer Weiterbildung ist vorgesehen, dass die Paillettenträgerfolie und/oder die Paillettendeckfolie und/oder eine weitere Paillettenträgerfolie und/oder eine weitere Paillettendeckfolie aus Polyethylenterephthalat (PET), Polymethylmethacrylat (PMMA), Polycarbonat (PC) oder Polyamid (PA) hergestellt ist. Derartige Materialen sind besonders geeignet für die Paillettenherstellung, insbesondere was deren Eignung zur Beschichtung mit einem metallischen Beschichtungsmaterial betrifft.

Im Rahmen einer Weiterbildung ist eine zwischen der Träger-Laminierfolie und der Deck-Laminierfolie angeordnete Anzahl lichtabsorbierend beschichteter Pailletten vorgesehen. Eine lichtabsorbierend beschichtete Paillette ist auf einer der teilreflektierenden Beschichtung abgewandten Seite der Paillette, insbesondere der Paillettenträgerfolie, mit einer lichtabsorbierenden Schicht versehen und/oder im Ergebnis lichtundurchlässig ausgebildet. Ein derartiger Folienverbund ist insbesondere geeignet in Weiterbildungen mit modulfreien Bereichen, das heißt Bereichen in denen kein Solarmodul angeordnet ist. Insbesondere entsprechen die lichtabsorbierend beschichteten Pailletten in ihrer Flächenform und/oder der teilreflektierenden Beschichtung den übrigen Pailletten des Folienverbundes und/oder sind in demselben Muster angeordnet, wodurch von der Außenseite vorteilhaft ein einheitlicher visueller Eindruck entsteht.

Im Rahmen einer Weiterbildung ist mindestens ein Solarmodul vorgesehen mit einer zum Aufnehmen von Lichtstrahlung ausgebildeten Moduloberfläche, insbesondere ein Photovoltaikmodul oder ein Solarthermiemodul.

Im Rahmen einer Weiterbildung, in der das mindestens eine Solarmodul ein Photovoltaikmodul ist, ist

- eine hinter dem mindestens einen Photovoltaikmodul angeordnete und einer Innenseite zugewandte, Hintergrund-Laminierfolie vorgesehen, wobei
- das mindestens eine Photovoltaikmodul zwischen der Träger-Laminierfolie und der Hintergrund-Laminierfolie einlaminiert ist. "Hinter dem Photovoltaikmodul" bezieht sich dabei auf die von der Moduloberfläche abgewandte Seite des Photovoltaikmoduls. In Weiterbildungen, in denen ein oder mehrere Solarmodule, insbesondere Photovoltaikmodule, innerhalb des Folienverbundes angeordnet sind, können einzelne Solarmodule miteinander verbunden sein, insbesondere über Anschlüsse, Verbindungen, Verkabelungen oder dergleichen. Die Solarmodule können über einen oder mehrere Anschlüsse, die insbesondere mit einem Stecker, Dose oder dergleichen Terminal aus dem Folienverbund, der Solarmodulanordnung und/oder dem Solarmodul herausgeführt sind, mit einem übergeordneten System, insbesondere einem Stromnetz, zur Nutzung der gewonnenen Energie verbunden werden.

In einer Weiterbildung ist vorgesehen, dass der Folienverbund in einem modulfreien Bereich, in dem kein Solarmodul angeordnet ist, eine Anzahl von lichtundurchlässigen, insbesondere lichtabsorbierend beschichteten, Pailletten aufweist. Insbesondere weist der Folienverbund in dieser Weiterbildung in dem modulfreien Bereich ausschließlich lichtundurchlässige, insbesondere lichtabsorbierend beschichtete, Pailletten und keine weiteren Pailletten auf.

Die Erfindung führt in einem zweiten Aspekt auf ein Gebäudeverkleidungselement, aufweisend eine zu einer Außenseite gerichtete lichtdurchlässige Scheibe, insbesondere eine Glasscheibe, einen Folienverbund gemäß dem ersten Aspekt der Erfindung und eine Hintergrundscheibe. Das Gebäudeverkleidungselement ist aufgrund der Eigenschaften des Folienverbundes gemäß dem ersten Aspekt der Erfindung insbesondere ausgebildet, mit einem Solarmodul kombiniert zu werden, insbesondere auf die Moduloberfläche eines Solarmoduls angebracht zu werden. Ein Gebäudeverkleidungselement kann insbesondere als Fassadenverkleidungselement oder als Dachverkleidungselement eingesetzt werden.

Bei dem Gebäudeverkleidungselement gemäß dem zweiten Aspekt der Erfindung werden die Vorteile des Folienverbunds gemäß dem ersten Aspekt der Erfindung vorteilhaft genutzt. In einer bevorzugten Weiterbildung des Gebäudeverkleidungselements ist die lichtdurchlässige Scheibe auf der Deck-Laminierfolie angeordnet und die Hintergrundscheibe auf der Träger-Laminierfolie angeordnet. Die Hintergrundscheibe ist insbesondere lichtdurchlässig.

Die lichtdurchlässige Scheibe und/oder die Hintergrundscheibe ist insbesondere als eine Glasscheibe ausgebildet, und kann als Klarglas, insbesondere als Floatglas oder Weißglas, oder als Strukturglas ausgebildet sein. In anderen Weiterbildungen kann die Hintergrundscheibe als lichtundurchlässige Scheibe ausgebildet sein, beispielsweise als Hintergrund-Deckplatte in Form einer lichtundurchlässigen Kunststoffscheibe oder dergleichen Deckplatte.

Die Erfindung führt in einem dritten Aspekt auf einen Solarglasverbund. Eine Weiterbildung des Solarglasverbundes, weist einen Folienverbund gemäß dem ersten Aspekt der Erfindung, eine - insbesondere auf der Deck-Laminierfolie des Folienverbundes angeordnete - lichtdurchlässige Scheibe und ein - insbesondere auf der Träger-Laminierfolie des Folienverbundes angeordnetes - Solarmodul auf. Die lichtdurchlässige Scheibe ist insbesondere transparent ausgebildet. Die lichtdurchlässige Scheibe ist insbesondere eine Glasscheibe und kann als Klarglas, insbesondere als Floatglas oder Weißglas, oder als Strukturglas ausgebildet sein. In dieser Weiterbildung weist der Folienverbund insbesondere kein einlaminiertes Solarmodul auf, wenngleich der gesamte Solarglasverbund, insbesondere die lichtdurchlässige Scheibe, die Deck-Laminierfolie, die Träger-Laminierfolie und das Solarmodul bevorzugt in einem Laminierverfahren zusammengefügt werden kann.

Eine Weiterbildung des Solarglasverbundes weist eine - insbesondere auf der Deck-Laminierfolie des Folienverbundes angeordnete - lichtdurchlässige Scheibe, einen Folienverbund (100) gemäß dem ersten Aspekt der Erfindung und eine Hintergrundscheibe auf. In dieser Weiterbildung weist der Folienverbund insbesondere eine Hintergrund-Laminierfolie und mindestens ein zwischen der Träger-Laminierfolie und der Hintergrund-Laminierfolie angeordnetes Solarmodul, insbesondere Photovoltaikmodul, auf. In dieser Weiterbildung ist die Hintergrundscheibe insbesondere auf der Hintergrund-Laminierfolie angeordnet.

In Weiterbildungen des Solarglasverbundes kann die Hintergrundscheibe als lichtdurchlässige Scheibe ausgebildet sein. Derartige Weiterbildungen ermöglichen insbesondere vorteilhaft eine Durchschaubarkeit in modulfreien Bereichen, das heißt Bereichen, in denen kein Solarmodul angeordnet ist.

In anderen Weiterbildungen des Solarglasverbundes kann die Hintergrundscheibe als lichtundurchlässige Scheibe, insbesondere als Hintergrund-Deckplatte, ausgebildet sein. Insbesondere in Weiterbildungen mit einem im Folienverbund angeordneten Solarmodul kann eine lichtundurchlässige Hintergrundscheibe vorteilhaft eingesetzt werden, da sie in Richtung der einfallenden Lichtstrahlung hinter dem Solarmodul angeordnet ist und somit das Solarmodul nicht verschattet.

Bei dem Solarglasverbund gemäß dem dritten Aspekt der Erfindung werden die Vorteile des Folienverbunds gemäß dem ersten Aspekt der Erfindung vorteilhaft genutzt.

In einer bevorzugten Weiterbildung des Solarglasverbunds ist die lichtdurchlässige Scheibe auf der Deck-Laminierfolie angeordnet und zu einer Außenseite gerichtet. In einer bevorzugten Weiterbildung des Solarglasverbunds ist das Solarmodul auf einer Innenseite, insbesondere mit der Moduloberfläche zu der Träger-Laminierfolie gerichtet, angeordnet.

Bei einer Weiterbildung des Solarglasverbundes ist vorgesehen, dass die Solarmodulanordnung zur Bildung eines Sandwichelements zwischen einer zu einer Außenseite gerichteten lichtdurchlässigen Scheibe und einer zu einer Innenseite gerichteten, Hintergrundscheibe angeordnet ist. Die Hintergrundscheibe kann lichtdurchlässig oder lichtundurchlässig ausgebildet sein.

Der zuvor erläuterte erfindungsgemäße und weitergebildete Folienverbund weist Wertebereiche hinsichtlich optischer Dichte und Flächenbedeckungsgrad auf, die gemäß dem Konzept der Erfindung besonders für eine Anwendung mit einem Solarmodul ausgebildet sind.

In einer nicht zur vorliegenden Erfindung gehörigen Alternative eines anderen Folienverbundes ist es gleichwohl möglich ebenfalls teilreflektierende Pailletten mit einer abweichenden optischen Dichte und einem abweichenden Flächenbedeckungsgrad anzuordnen. Dies kann andere Vorteile bieten, insbesondere hinsichtlich der Erzeugung eines Reflexionseffekts.

So kann in einer derartigen Alternative zu dem erfinderischen Konzept ein Folienverbund vorgesehen werden, ausgebildet zur Anordnung in einem Sonnenschutzglasverbund, wobei der Folienverbund aufweist:

- eine Deck-Laminierfolie,
- eine Träger-Laminierfolie,
- eine zwischen der Träger-Laminierfolie und der Deck-Laminierfolie angeordnete Anzahl von Pailletten.

Bei einer derartigen Alternative ist vorgesehen, dass

- die Paillette eine lichtdurchlässige Paillettenträgerfolie aufweist, eine teilreflektierende, insbesondere metallische, Beschichtung aufweist, derart, dass ein Teil einfallender Lichtstrahlung als transmittierte Lichtstrahlung transmittiert und ein Teil einfallender Lichtstrahlung (S) als reflektierte Lichtstrahlung reflektiert wird, wobei

- die teilreflektierende Beschichtung eine optische Dichte aufweist, und
die optische Dichte zwischen 0,3 und 0,85, bevorzugt zwischen 0,5 und 0,85 liegt, und

- die teilreflektierende Beschichtung der Paillette ausgebildet ist, mittels der reflektierten Lichtstrahlung einen, insbesondere wahrnehmbaren, Reflexionseffekt zu erzeugen, und

- die Pailletten im Folienverbund eine Fläche bedecken, sodass ein Flächenbedeckungsgrad zwischen 0,3 und 0,95, bevorzugt zwischen 0,3 und 0,85, besonders bevorzugt zwischen 0,5 und 0,7 ist.

Eine derartige Alternative eines anderen Folienverbundes unterscheidet sich somit wenigstens in den Wertebereichen der optischen Dichte und des Flächenbedeckungsgrades. Die Alternative eines anderen Folienverbundes ist mit sämtlichen Weiterbildungen des Folienverbundes gemäß dem ersten Aspekt der Erfindung kombinierbar.

Die Alternative eines anderen Folienverbundes schließt die überraschende Erkenntnis ein, dass ein gewisser Grad an transmittiertem Licht, auch bei Sonnenschutzglas sogar gewünscht sein kann, beispielsweise um die visuelle Erscheinung der Pailletten in der Wahrnehmung bei einer Betrachtung von einer Innenseite abzuschwächen. Eine solche Einstellung des Transmissionsverhaltens ist mittels der Anpassung der optischen Dichte - unter Beibehaltung eines Reflexionseffekts - mit einem Folienverbund gemäß dieser Alternative möglich - dies insbesondere vorteilhaft, wenn der Folienverbund statt mit einem Solarmodul mit einer lichttransmissionsmindernden Scheibe eingesetzt wird. Ein Folienverbund gemäß der Alternative, der bevorzugt mit einer lichttransmissionsmindernden Scheibe kombinierbar ist, wird somit im verbauten Zustand in der Regel auch von der Innenseite sichtbar sein.

Durch die teilreflektierende Eigenschaft der Pailletten wird hierbei eine größere Gestaltungsfreiheit erreicht, da - im Vergleich zu bekannten, lichtundurchlässigen bzw. vollreflektierenden Pailletten - beispielsweise zugunsten einer größeren reflektierenden Fläche ein höherer Flächenbedeckungsgrad gewählt werden kann, und durch eine entsprechend niedrigere optische Dichte trotzdem eine nur relativ gering eingeschränkte Durchschaubarkeit des Folienverbundes von einer Innenseite gewährleistet werden kann. Durch die Färbung bzw. Verdunklung der lichttransmissionsmindernden Scheibe resultiert vorteilhaft eine bereits relativ schwache visuelle Erscheinung der Pailletten von der Innenseite.

Durch ein entsprechendes Einstellen, insbesondere Erhöhen, der optische Dichte der Pailletten, kann der Anteil des an der Beschichtung der Paillette reflektiertem Licht vorteilhaft erhöht werden, um die Funktion der lichttransmissionsmindernden Scheibe zu unterstützen.

Ein allgemein höherer Flächenbedeckungsgrad, insbesondere in dem im Rahmen der Alternative eines anderen Folienverbundes angegebenen Bereich, ist vorteilhaft, um den Anteil des an der Beschichtung der Paillette reflektiertem Licht zu erhöhen, um wiederum die Funktion der lichttransmissionsmindernden Scheibe zu unterstützen.

Eine lichttransmissionsmindernde Scheibe bietet den Vorteil einer Absorption und/oder Reflexion von einfallendem Licht in ein Gebäude und weist hierzu insbesondere eine Färbung auf, die beispielsweise durch eine Beschichtung oder die Beimischung von Partikeln in das Glasmaterial bei der Herstellung erreicht werden. Wenn eine transmissionssenkende Scheibe eingesetzt wird, liegt die Funktion des Folienverbundes insbesondere darin, einen größeren Anteil an reflektiertem Licht, und einen geringeren Anteil an transmittiertem Licht zu erzeugen - dies ist insbesondere im Unterschied zu einer Anwendung zu sehen, in der ein Solarmodul eingesetzt wird.

Eine derartige Alternative eines anderen Folienverbundes kann in einem Gebäudeverkleidungselement mit einer lichtdurchlässigen Scheibe und einer, insbesondere lichtdurchlässigen, Hintergrundscheibe kombiniert werden.

Im Zusammenhang mit der Alternative eines anderen Folienverbundes wird ein Sonnenschutzglasverbund vorgeschlagen, aufweisend eine transparente Scheibe, einen Folienverbund gemäß der Alternative eines anderen Folienverbundes und mindestens eine lichttransmissionsmindernde Scheibe, bevorzugt ein gefärbtes Glas oder ein schaltbar tönbares Glas. Ein gefärbtes Glas kann insbesondere als ein Grauglas ausgebildet sein. Ein schaltbar tönbares Glas kann insbesondere als ein elektronisch schaltbar tönbares Glas ausgebildet sein, bei dem durch das Anlegen einer elektrischen Spannung die Lichtdurchlässigkeit angepasst werden kann. Elektronisch schaltbar tönbares Glas wird auch als elektrochromes Glas bezeichnet. Alternativ oder zusätzlich kann das schaltbar tönbare Glas auch photochrome - das heißt bei sich ändernden Lichtverhältnissen die Lichtdurchlässigkeit ändernd - und/oder thermochrome - das heißt bei sich ändernden Temperaturverhältnissen die Lichtdurchlässigkeit ändernd - Eigenschaften aufweisen. Ein schaltbar tönbares Glas kann insbesondere über ein Steuergerät geschaltet oder gesteuert oder geregelt werden. Die Sonnenschutz-Modulanordnung kann mit einer transparenten Scheibe zu einem Sonnenschutzglasverbund kombiniert werden.

Ausführungsformen der Erfindung werden nun nachfolgend anhand der Zeichnung beschrieben. Diese soll die Ausführungsformen nicht notwendigerweise maßstäblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in der Zeichnung sowie in den Ansprüchen offenbarten Merkmale der Erfindung können sowohl einzeln als auch in beliebiger Kombination für die Weiterbildung der Erfindung wesentlich sein. Zudem fallen in den Rahmen der Erfindung alle Kombinationen aus zumindest zwei der in der Beschreibung, der Zeichnung und/oder den Ansprüchen offenbarten Merkmale. Die allgemeine Idee der Erfindung ist nicht beschränkt auf die exakte Form oder das Detail der im Folgenden gezeigten und beschriebenen bevorzugten Ausführungsformen oder beschränkt auf einen Gegenstand, der eingeschränkt wäre im Vergleich zu dem in den Ansprüchen beanspruchten Gegenstand. Bei angegebenen Bemessungsbereichen sollen auch innerhalb der genannten Grenzen liegende Werte als Grenzwerte offenbart und beliebig einsetzbar und beanspruchbar sein. Der Einfachheit halber sind nachfolgend für identische oder ähnliche Teile oder Teile mit identischer oder ähnlicher Funktion gleiche Bezugszeichen verwendet.

Weitere Vorteile, Merkmale und Einzelheiten der Erfindung ergeben sich aus der nachfolgenden Beschreibung der bevorzugten Ausführungsformen sowie anhand der Zeichnung; diese zeigt in:

Fig. 1A, Fig. 1B, Fig. 1C     drei Ausführungsformen jeweils eines Folienverbundes gemäß dem Konzept der Erfindung jeweils mit einem ersten, zweiten und dritten Schichtaufbau,

Fig. 2     eine Prinzipskizze zum Konzept der Erfindung zur Verdeutlichung der teilweisen Reflexion der Pailletten,

Fig. 3A     eine Ausführungsform eines Solarglasverbundes mit einem schematisch, nicht maßstäblich dargestellten Schichtaufbau eines Folienverbundes gemäß dem Ausführungsbeispiel der Fig. 1A, verbaut zwischen einem Solarmodul und einer lichtdurchlässigen Scheibe des Solarglasverbundes - oder in einer Alternative der Erfindung, ein Sonnenschutzglasverbund, der anstelle eines Solarmoduls eine lichttransmissionsmindernde Scheibe aufweist,

Fig. 3B     eine Ausführungsform eines Gebäudeverkleidungselements, welches zusammen mit einem Solarmodul zu einer weiteren Ausführungsform eines Solarglasverbundes kombiniert werden kann,

Fig. 4A, Fig. 4B, Fig. 4C     eine erste und eine zweite Ausführungsform eines Solarglasverbundes mit einem Folienverbund im Aufbau gemäß dem Ausführungsbeispiel der Fig. 1A,

Fig. 5     ein schematischer Schichtaufbau des Solarglasverbundes der Fig. 3 mit Angabe der Schichtstärken zum Konzept der Erfindung,

Fig. 6A     eine erste Ausführungsform einer Paillette,

Fig. 6B     eine zweite Ausführungsform einer Paillette, aufweisend eine auf der Paillettendeckfolie angeordnete Beschichtung,

Fig. 6C     eine Ausführung einer als Dekorfolie ausgebildeten Paillettendeckfolie, die mit Pailletten sämtlicher Ausführungsformen kombinierbar ist,

Fig. 6D     eine dritte Ausführungsform einer Paillette, aufweisend eine im Vergleich zur Ausführungsform einer Paillette der Fig. 6A weitere Paillettenträgerfolie mit einer weiteren Beschichtung,

Fig. 6E      eine vierte Ausführungsform einer Paillette, aufweisend eine im Vergleich zur Ausführungsform einer Paillette der Fig. 6A weitere Paillettendeckfolie mit einer weiteren Beschichtung,

Fig. 6F      eine fünfte Ausführungsform einer Paillette, mit einer Oberflächenstrukturierung aufbauend auf der Ausführungsform einer Paillette der Fig. 6A,

Fig. 6G      eine Abwandlung einer bevorzugten Ausführungsform einer Paillette der Fig. 6A bis Fig. 6F, die zusätzlich eine lichtabsorbierende Beschichtung aufweist;

Fig. 7A      ohne Darstellung eines Reflexionseffekts, eine Vorderansicht eines bevorzugten Ausführungsbeispiels eines Solarglasverbundes mit einem Folienverbund gemäß dem Konzept der Erfindung mit einem Solarmodul, wobei das Solarmodul Oberflächenstrukturen aufweist,

Fig. 7B, Fig. 7C      zur Darstellung eines Reflexionseffekts, eine Vorderansicht eines weiteren bevorzugten Ausführungsbeispiels eines Solarglasverbundes mit einem Folienverbund gemäß dem Konzept der Erfindung mit dem Reflexionseffekt aus einer ersten und einer zweiten Blickrichtung,

Fig. 7D      zur Darstellung eines Reflexionseffekts, eine Vorderansicht eines weiteren bevorzugten Ausführungsbeispiels eines Solarglasverbundes mit einem Folienverbund gemäß dem Konzept der Erfindung, aufweisend Pailletten mit einer Oberflächenstrukturierung zum Erzeugen eines dreidimensionalen Reflexionseffekts,

Fig. 7E      ein Ausschnitt eines Solarglasverbundes mit einer Paillette zur Veranschaulichung eines ersten Flächenbedeckungsgrad und eines zweiten Flächenbedeckungsgrades,

Fig. 7F      eine Vorderansicht eines weiteren bevorzugten Ausführungsbeispiels eines Solarglasverbundes mit einem Folienverbund gemäß dem Konzept der Erfindung, aufweisend Pailletten mit einer streifenförmigen Flächenform,

Fig. 8A bis Fig. 8G      jeweils eine schematische Darstellung einer bevorzugten unterschiedlichen Flächenform einer Paillette zur Einbringung in eine bevorzugte Ausführungsform eines Folienverbundes;

Fig. 8H      eine Darstellung einer weiteren bevorzugten Paillette mit einer veränderlichen Beschichtung, nämlich eine lateral variierende Beschichtung in Form einer Gradienten-Beschichtung, zur Einbringung in eine bevorzugte Ausführungsform eines Folienverbundes;

Fig. 9      ein Diagramm mit wellenlängenabhängigen Transmissions- und Reflexionsverläufen von vier Beschichtungen unterschiedlicher optischer Dichten,

Fig. 10      ein Gebäude mit Gebäudeverkleidungselementen und Sonnenschutzverbundgläsern, jeweils aufweisend Folienverbunde gemäß dem Konzept der Erfindung.

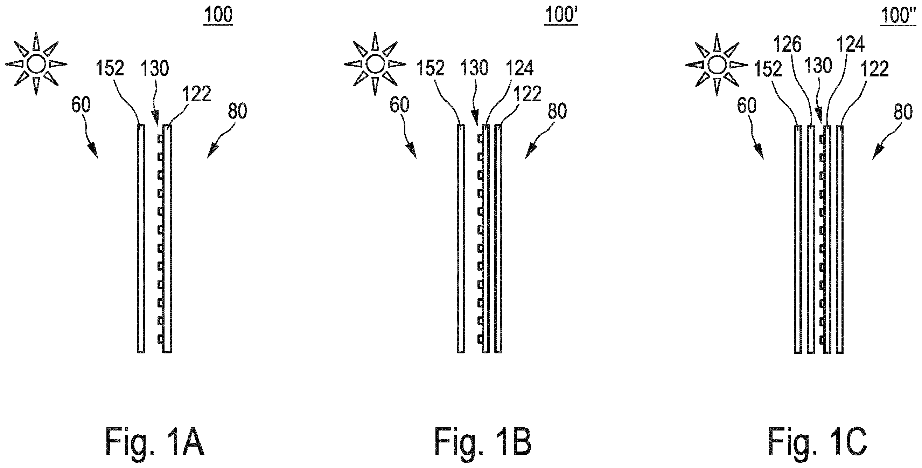

Fig. 1A zeigt einen schematischen Schichtaufbau eines Folienverbundes 100 gemäß dem Konzept der Erfindung. Der Folienverbund 100 weist auf einer, insbesondere einem hier nicht dargestellten Gebäude, Fassadenelement oder Solarmodul zugewandten Innenseite 80 eine Träger-Laminierfolie 122 auf. Der Folienverbund 100 weist weiter auf einer der äußeren Umgebung zugewandten Außenseite 60 eine Deck-Laminierfolie 152 auf.

Zwischen der Träger-Laminierfolie 122 und der Deck-Laminierfolie 152 ist eine Anzahl an Pailletten 130 angeordnet.

Durch den Zusammenhalt der Laminierfolien 122, 152 im laminierten Zustand des Folienverbundes 100 wird die Anzahl an Pailletten 130 im Folienverbund 100 fixiert.

In Weiterbildungen kann eine Paillette 130 insbesondere über eine optionale, hier nicht dargestellte Klebstoffschicht auf der Träger-Laminierfolie 122 fixiert werden. Dies kann insbesondere über ein maschinelles Verfahren erfolgen, beispielsweise über eine numerisch gesteuerte Positioniervorrichtung. Auf diese Weise kann eine Anzahl an Pailletten 130 gemäß vordefinierter Muster mit definierten Abständen auf die Träger-Laminierfolie 122 aufgebracht werden. Der in Fig. 1A dargestellte Abstand zwischen der Deck-Laminierfolie 152 und der Träger-Laminierfolie 122 dient lediglich der besseren Übersicht des Schichtaufbaus und ist im laminierten Zustand des Folienverbundes 100, wenn die Deck-Laminierfolie 152 die Anzahl an Pailletten 130 schützend bedeckt, in dieser Form nicht vorhanden. Insbesondere liegt in den Zwischenräumen zwischen den Pailletten 130 die Träger-Laminierfolie 122 direkt auf der Deck-Laminierfolie 152 auf. Die Träger-Laminierfolie 122 und die Deck-Laminierfolie 152 sind lichtdurchlässig ausgebildet. Die Träger-Laminierfolie 122 und/oder die Deck-Laminierfolie 152 können insbesondere derart ausgebildet sein, dass sie - in einem Zustand vor der Lamination zu einem Folienverbund 100 - transluzent sind, insbesondere trüb lichtdurchlässig, und während der Lamination, insbesondere durch Temperatur- und/oder Druckeinfluss, transparent werden.

In Fig. 1B ist eine zweite bevorzugte Ausführungsform eines Folienverbundes 100' gezeigt. Der Folienverbund 100' weist zwischen der Träger-Laminierfolie 122 und der Anzahl an Pailletten 130 eine zusätzliche Zwischen-Trägerfolie 124 auf, auf der die Anzahl an Pailletten 130 befestigt ist. Die Zwischen-Trägerfolie 124 ist lichtdurchlässig ausgebildet. In einer derartigen Ausführungsform kann zunächst die Zwischen-Trägerfolie 124 mit der Anzahl an Pailletten 130 gemäß einem vorbestimmten Muster bestückt werden, bevor das Laminieren mit der Träger-Laminierfolie 122 und der Deck-Laminierfolie 152 zu dem Folienverbund 100' erfolgt.

In Fig. 1C ist eine dritte bevorzugte Ausführungsform eines Folienverbundes 100" gezeigt, bei der - zusätzlich zu der in Fig. 1B gezeigten Ausführungsform - zwischen der Deck-Laminierfolie 152 und der Anzahl an Pailletten 130 eine lichtdurchlässige Zwischen-Deckfolie 126 angeordnet ist. Insbesondere kann eine Herstellung des Folienverbundes 100" derart erfolgen, dass zunächst die Anzahl an Pailletten 130 zwischen die Zwischen-Deckfolie 126 und die Zwischen-Trägerfolie 124 zu einem Zwischenlaminat 128 laminiert wird, und dieses Zwischenlaminat 128 anschließend zwischen die Deck-Laminierfolie 152 und die Träger-Laminierfolie 122 laminiert wird.

Die Zwischen-Deckfolie 126 und/oder die Zwischen-Trägerfolie 124 können insbesondere aus einem Material mit guten Haftungseigenschaften für die Pailletten, beispielsweise Polyethylenterephthalat (PET), gebildet sein. Die Deck-Laminierfolie 152 und die Träger-Laminierfolie 122 hingegen können aus einem davon unterschiedlichen Material gebildet sein, beispielsweise Ethylen-Vinylacetat (EVA).

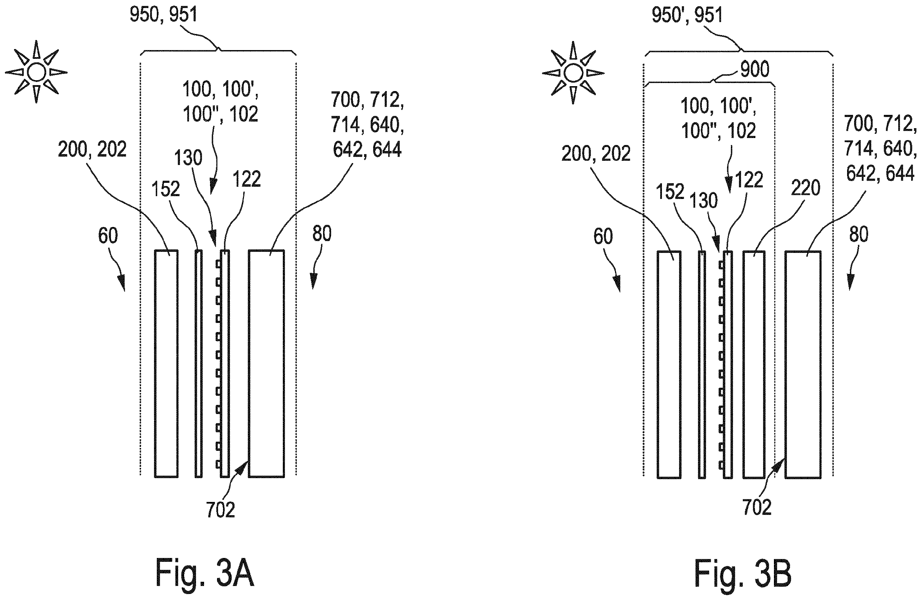

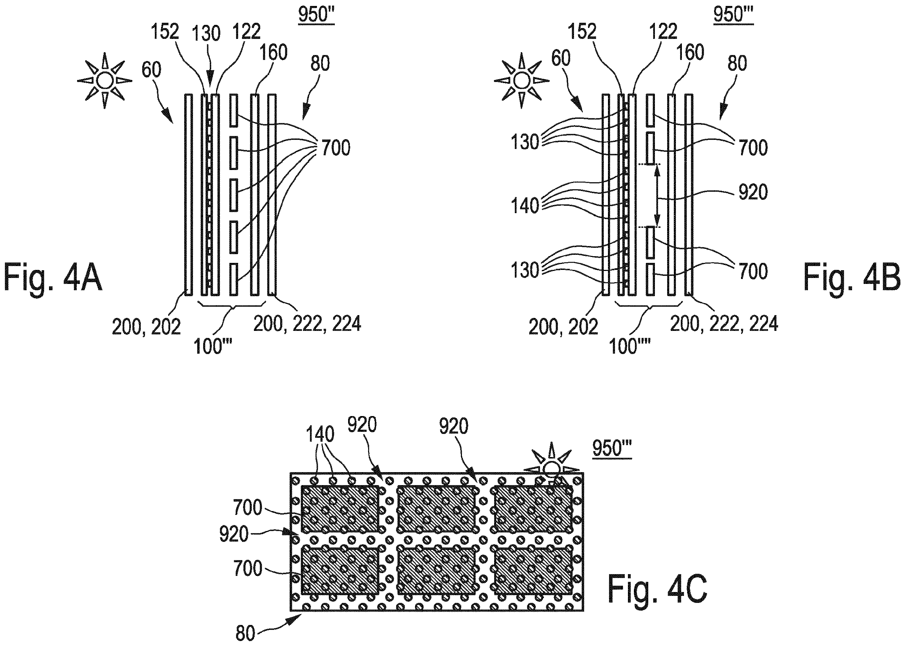

Die in Fig. 1B und Fig. 1C gezeigten Ausführungsformen eines Folienverbundes können - insbesondere alternativ zu der in Fig. 1A gezeigten Ausführungsform eines Folienverbundes - auch in anderen Ausführungsformen - insbesondere in den im nachfolgenden beschriebenen Fig. 3, Fig. 4A und Fig. 4B gezeigten Ausführungsformen eines Solarglasverbundes - eingesetzt werden.

Die in den Figuren gezeigte vertikale Ausrichtung des Folienverbundes 100, 100', 100" kann selbstverständlich auch eine Neigung aufweisen oder horizontal ausgebildet sein, beispielsweise bei einer Dachinstallation.

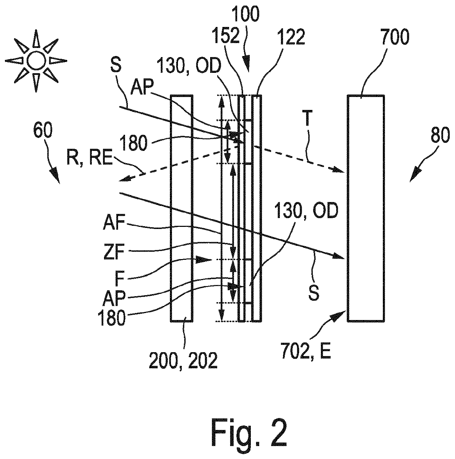

Fig. 2 zeigt in einer weiteren schematischen Darstellung einen Ausschnitt des Folienverbunds 100, der zwischen einer lichtdurchlässigen Scheibe 200, insbesondere einer Glasscheibe 202, und einem Solarmodul 700 angeordnet ist, zur Erläuterung des Konzepts der Erfindung. Zu sehen ist ein Ausschnitt mit zwei Pailletten 130, die jeweils durch eine hier nicht näher dargestellte Beschichtung 180 eine optische Dichte OD aufweisen und somit zu einem bestimmten Grad, welcher durch die optische Dichte OD charakterisiert ist, lichtdurchlässig sind. Die Pailletten 130 sind somit ausgebildet, einen Teil einer einfallenden Lichtstrahlung S als transmittierte Lichtstrahlung T durchzulassen und einen Teil der einfallenden Lichtstrahlung S als reflektierte Lichtstrahlung R zum Erzeugen eines Reflexionseffekts RE zu spiegeln.

Die Pailletten 130 sind in oben beschriebener Weise zwischen einer Deck-Laminierfolie 152 und einer Träger-Laminierfolie 122 des Folienverbunds 100 angeordnet. Die Deck-Laminierfolie 152 und die Träger-Laminierfolie 122 sind lichtdurchlässig ausgebildet, das heißt sie lassen Lichtstrahlung S, die von einer Außenseite 60 auf sie fällt, vollständig - oder allenfalls bis außer einen vernachlässigbar kleinen Anteil - auf eine Moduloberfläche 702 des Solarmoduls 700 durchtreten. Das Solarmodul 700 ist dabei auf der Innenseite 80, hinter dem Folienverbund 100 angeordnet.

Der Folienverbund 100 ist somit in einer Zwischenfläche ZF, nämlich einem Bereich der Folienfläche AF, in dem keine Pailletten 130 angeordnet sind, vollständig oder nahezu vollständig lichtdurchlässig ausgebildet. Für den von Pailletten 130 bedeckten Teil der Fläche, das heißt für eine Paillettenfläche AP gilt hingegen, dass ein erster Teil der einfallenden Lichtstrahlung S als transmittierte Lichtstrahlung T durch die Paillette 130 und somit ebenfalls auf die Moduloberfläche 702 geleitet wird, ein zweiter Teil der einfallenden Lichtstrahlung S als reflektierte Lichtstrahlung R in die auf der Außenseite 60 liegende Umgebung reflektiert wird und auf diese Weise insbesondere ein Reflexionseffekt RE erzeugt wird. Durch die optische Dichte OD, welche aus der- hier nicht dargestellten -teilreflektierenden Beschichtung 180 resultiert, kann das Verhältnis zwischen transmittierter Lichtstrahlung T und reflektierter Lichtstrahlung R nach Bedarf oder für eine bestimmte Anwendung gewählt werden. Ein höherer Wert der optischen Dichte OD führt dabei zu einer geringeren Transmission, das heißt einer geringeren transmittierter Lichtstrahlung T, und entsprechend einer höheren reflektierten Lichtstrahlung R. Entsprechend führt ein geringerer Wert der optischen Dichte OD zu einer höheren Transmission, das heißt einer höheren transmittierten Lichtstrahlung T und entsprechend einer geringeren reflektierten Lichtstrahlung R.

Somit kann mit einer höheren optischen Dichte OD generell eine Verstärkung des Reflexionseffekts RE erreicht werden, und mit einer geringeren optischen Dichte OD generell eine Verstärkung der Energieausbeute E des Solarmoduls 700. Es ist daher vorteilhaft, die optische Dichte OD in Bezug auf einen Flächenbedeckungsgrad F so zu wählen, dass bei möglichst hoher Energieausbeute E noch ein ausreichend starker Reflexionseffekt RE zum visuellen Kaschieren des Solarmoduls 700 erzeugt wird.

Der Flächenbedeckungsgrad F beschreibt das Verhältnis von der Paillettenfläche AP zu der Folienfläche AF, das heißt das Verhältnis von der von Pailletten 130 bedeckten Fläche des Folienverbundes 100 zu der gesamten Fläche des Folienverbundes 100.

Fig. 3A zeigt einen Folienverbund 100 in einer Einbausituation. Gleichwohl sind andere Ausführungsformen des Folienverbundes 100, 100', 100" in der gezeigten Einbausituation anwendbar. Insbesondere, können die nachfolgend in Fig. 3A, Fig. 3B, Fig. 4A, Fig. 4B, Fig. 5 darstellten Ausführungsformen anstelle des gezeigten Folienverbundes 100 auch einen Folienverbund 100' mit einer Zwischen-Trägerfolie 124 oder einen Folienverbund 100" mit einer Zwischen-Trägerfolie 124 und/oder einer Zwischen-Deckfolie 126 aufweisen.

Der Folienverbund 100 kann mit seiner auf der Innenseite 80 liegenden Träger-Laminierfolie 122 auf ein Solarmodul 700 aufgebracht sein, wobei der Folienverbund 100 entsprechend auf dessen Moduloberfläche 702 aufgebracht ist. Das Solarmodul 700 ist bevorzugt als Photovoltaikmodul 712 ausgebildet. In alternativen Ausführungsformen kann das Solarmodul 700 auch als Solarthermiemodul 714 ausgebildet sein.

Ein Folienverbund 100, 100', 100" bildet mit einem Solarmodul 700 auf der Innenseite 80 und einer lichtdurchlässigen Scheibe 200 auf der Außenseite 60 einen Solarglasverbund 950. Die lichtdurchlässige Scheibe 200 kann insbesondere als Glasscheibe 202, beispielsweise aus einem Klarglas oder einem Strukturglas, gebildet sein.

Die Folien eines Folienverbundes 100, 100', 100" insbesondere eine Träger-Laminierfolie 122, eine Deck-Laminierfolie 152 und/oder eine Zwischen-Trägerfolie 124, werden in der Regel unter Wärmeeinfluss und Vakuum, sowie gegebenenfalls unter Druckeinfluss zu einem Folienverbund in Form eines Laminierverbundes verbunden, wodurch die Pailletten 130 in dem Folienverbund 100, 100', 100" eingeschlossen und dauerhaft fixiert werden können. Dabei können insbesondere thermoplastische Eigenschaften von Laminierfolien genutzt werden dahingehend, dass ein Erwärmen des Folienverbundes ein Aufschmelzen einer oder mehrerer Laminierfolien bewirkt, welche dann mittels Druck miteinander verbunden werden können. Die hergestellte Verbindung ist insbesondere stoffschlüssig.

In analoger Weise kann ein Folienverbund 100, 100', 100" unter Wärmeeinfluss und Vakuum, sowie gegebenenfalls unter Druckeinfluss mit einer lichtdurchlässigen Scheibe 200 und einem Solarmodul 700 in einem Laminierverfahren dauerhaft zu einem Solarglasverbund 950 verbunden werden. Insbesondere weisen der Folienverbund 100, 100', 100", die lichtdurchlässige Scheibe 200 und das Solarmodul 700 die gleichen Flächenabmessungen, das heißt Länge und Breite auf, sodass ein Solarglasverbund 950 mit diesen Flächenabmessungen entsteht.

In einem bevorzugten Herstellprozess können eine lichtdurchlässige Scheibe 200, eine Deck-Laminierfolie 152, eine Träger-Laminierfolie 122 und ein Solarmodul 700 in einem Schritt, insbesondere ohne Zwischenschritte oder -produkte, in einem Laminierverfahren zu einem Solarglasverbund 950 zusammengefügt werden.

In einer Alternative der Erfindung, bei der ein Folienverbund 102 mit angepasster optischer Dichte OD und/oder Flächenbedeckungsgrad F vorgesehen ist, kann der Folienverbund 102 zur Kombination mit einer lichttransmissionsmindernden Scheibe 640 vorgesehen sein. Anstelle eines Solarmoduls 700 ist somit eine lichttransmissionsmindernde Scheibe 640, insbesondere ein gefärbtes Glas 642 oder ein schaltbar tönbares Glas 644 vorgesehen. Das gefärbte Glas 642 kann insbesondere ein Grauglas sein. Selbstverständlich sind auch andere Färbungen im Rahmen der Erfindung möglich, beispielsweise Braun, Grün, Blau und dergleichen transmissionssenkende Färbung.

Der Folienverbund 102 bildet zusammen mit der lichttransmissionsmindernden Scheibe 640 auf der Innenseite 80 und einer lichtdurchlässigen Scheibe 200 auf der Außenseite 60 einen Sonnenschutzglasverbund 951. Ein Sonnenschutzglasverbund 951 kann analog zu einem Solarglasverbund 950 hergestellt werden, indem unter Wärmeeinfluss und Vakuum, sowie gegebenenfalls unter Druckeinfluss der Folienverbund 102 mit einer lichtdurchlässigen Scheibe 200 und einer lichttransmissionsmindernden Scheibe 640 dauerhaft zu einem Sonnenschutzglasverbund 951 verbunden wird. In einem bevorzugten Herstellprozess können eine lichtdurchlässige Scheibe 200, eine Deck-Laminierfolie 152, eine Träger-Laminierfolie 122 und eine lichttransmissionsmindernde Scheibe 640 in einem Schritt, insbesondere ohne Zwischenprodukte, in einem Laminierverfahren zu einem Sonnenschutzglasverbund 951 zusammengefügt werden.

Fig. 3B zeigt eine Ausführungsform eines Gebäudeverkleidungselements 900, welches eine lichtdurchlässige Scheibe 200, einen Folienverbund 100, 100', 100" und eine Hintergrundscheibe 220 aufweist. Somit unterscheidet es sich insbesondere von dem in Fig. 3A gezeigten Aufbau dadurch, dass ein Solarmodul 700 nicht Bestandteil des Laminats ist. Das Gebäudeverkleidungselement 900 bildet somit einen eigenständigen Glasverbund, welcher aufgrund des darin enthaltenen Folienverbunds ausgebildet ist für die Kombination mit einem Solarmodul. Wie hier in Fig. 3B gezeigt, kann das Gebäudeverkleidungselement 900 mit einem Solarmodul 700 zu einem Solarglasverbund 950' kombiniert werden, insbesondere indem das Gebäudeverkleidungselement 900 vor oder auf der Moduloberfläche 702 des Solarmoduls 700 befestigt wird.

In alternativen Ausführungsformen kann das Solarmodul 700 auch als Solarthermiemodul 714 ausgebildet sein. Die in Fig. 3B gezeigte Ausführungsform ist mit der Alternative der Erfindung, kombinierbar insbesondere zur Bildung eines Sonnenschutzglasverbunds 951, der anstelle eines Solarmoduls 700 eine lichttransmissionsmindernde Scheibe 640 aufweist.

Fig. 4A zeigt eine bevorzugte Ausführungsform im Rahmen der Erfindung. Der Folienverbund 100‴ weist dabei auf der Innenseite 80 eine zusätzliche, Hintergrund-Laminierfolie 160 auf. Zwischen der Träger-Laminierfolie 122 und der Hintergrund-Laminierfolie 160 sind eine oder mehrere Solarmodule 700 angeordnet. In dieser Ausführungsform sind ein oder mehrere Solarmodule 700 in den Folienverbund 100‴ integriert.

Der Folienverbund 100‴ kann zwischen eine lichtdurchlässige Scheibe 200 auf der Außenseite 60, und eine Hintergrundscheibe 220 auf der Innenseite 80 zur Bildung eines Solarglasverbundes 950" angeordnet werden. Die lichtdurchlässige Scheibe 200 ist insbesondere eine Glasscheibe 202. Die Hintergrundscheibe 220 ist bevorzugt lichtdurchlässig. Die Hintergrundscheibe 220 ist insbesondere eine Hintergrund-Glasscheibe 222. Die Glasscheibe 202 und/oder die Hintergrund-Glasscheibe 222 können insbesondere als Klarglasscheibe oder Strukturglasscheibe ausgebildet sein. Gleichwohl kann die Hintergrundscheibe 220 auch als eine lichtundurchlässige Hintergrund-Deckplatte 224, insbesondere aus Kunststoff, gebildet sein.

Fig. 4B zeigt eine dritte Ausführungsform eines Folienverbundes 100⁗, welcher ähnlich ist zudem in Fig. 4A gezeigten Folienverbund 100‴, jedoch zusätzlich zu der Anzahl an Pailletten 130 eine oder mehrere lichtabsorbierend beschichtete Pailletten 140 aufweist. Die lichtabsorbierend beschichteten Pailletten 140 sind dabei bevorzugt in einem modulfreien Bereich 920 angeordnet. Der modulfreie Bereich 920 ist ein Bereich, in dem keine Solarmodule 700 vorgesehen bzw. angeordnet sind. Insbesondere sind in einem Bereich des Folienverbundes 100⁗, der Solarmodule 700 bedeckt, ausschließlich Pailletten 130, die teilreflektierend und teilweise lichtdurchlässig sind, angeordnet und in dem übrigen, modulfreien Bereich 920 ausschließlich lichtabsorbierend beschichtete Pailletten 140, die im Ergebnis lichtundurchlässig sind, angeordnet.

Die lichtabsorbierend beschichteten Pailletten 140 unterscheiden sich insbesondere dadurch durch die Pailletten 130, dass sie auf Ihrer der Innenseite 80 zugewandten Seite eine lichtabsorbierende, insbesondere schwarze, Beschichtung oder Lackierung aufweisen. Die lichtabsorbierend beschichteten Pailletten 140 weisen insbesondere auf ihrer der Außenseite 60 zugewandten Seite die gleiche oder eine ähnliche, hier nicht dargestellte metallische Beschichtung 180 auf wie die Pailletten 130 des Folienverbundes 100‴. Dadurch, dass sowohl die Pailletten 130, als auch die lichtabsorbierend beschichteten Pailletten 140 eine gleiche oder ähnliche Beschichtung 180 aufweisen, wird vorteilhaft über die gesamte Fläche des Folienverbundes 100⁗ - trotz des modulfreien Bereichs 920 - eine einheitliche optische Erscheinung, und insbesondere eine einheitliche Erzeugung eines Reflexionseffekts RE, gewährleistet. Dadurch, dass die lichtabsorbierend beschichteten Pailletten 140 auf ihrer der Innenseite 80 zugewandten Seite eine lichtabsorbierende Beschichtung oder Lackierung aufweisen, werden insbesondere vorteilhaft der visuelle Eindruck der Solarmodule 700 auch von der Innenseite 80 visuell kaschiert, da eine sonst von der Innenseite 80 sichtbare, regelmäßige Struktur der modulfreien Bereiche 920, insbesondere rasterartige Anordnung von Zeilen und/oder Spalten von modulfreien Bereichen 920, durch die Anordnung von lichtabsorbierend beschichteten Pailletten 140 unterbrochen wird. Durch die lichtabsorbierende Beschichtung 133 der lichtabsorbierend beschichteten Pailletten 140 wird hierzu die Sichtbarkeit von der Innenseite 80 vorteilhaft verbessert. Die Grenzen der einzelnen Solarmodule 700 sind dadurch nicht mehr so exakt wahrnehmbar, verglichen mit Ausführungsformen, in denen die modulfreien Bereiche keine lichtabsorbierend beschichteten Pailletten 140 aufweisen. Dieser Effekt ist in Fig. 4C in einer schematischen Ansicht eines, insbesondere des in Fig. 4B gezeigten, modulunterbrochenen Solarglasverbunds 950‴, von einer Innenseite 80 verdeutlicht. Der visuelle Eindruckdersonst aus regelmäßigen Zeilen und Spalten bestehenden Struktur der modulfreien Bereiche 920 wird durch die Anordnung der lichtabsorbierend beschichteten Pailletten 140 in den modulfreien Bereichen 920 reduziert, indem die Grenzen der Solarmodule 700 unterbrochen werden.

Auch wird durch die lichtabsorbierende Beschichtung 133 der Pailletten 140 das visuelle Kaschieren - aus Sicht der der Außenseite 60 - verbessert, da vorteilhaft ein relativ großer Kontrast der zwischen der teilreflektierenden Beschichtung 180 und der dahinterliegenden lichtabsorbierenden Beschichtung 133 zur Erzeugung des Reflexionseffekts RE erreicht werden kann, auch wenn kein Solarmodul 700 im Hintergrund liegt. Durch die lichtabsorbierende Beschichtung 133 wird somit der durch die lichtabsorbierend beschichteten Pailletten 140 erzeugte Reflexionseffekt RE durch einen ähnlich dunklen Hintergrund an den Reflexionseffekt RE der vor einem Solarmodul 700 angeordneten Pailletten 130 angeglichen, und - insbesondere trotz modulfreier Bereiche 920 - ein homogener Reflexionseffekt RE über die gesamte Fläche, insbesondere eines Solarglasverbunds, erzeugt. In anderen Weiterbildungen können lichtabsorbierend beschichtete Pailletten 140 auch anders ausgebildet sein, beispielsweise wie in WO 2019/038288 A1 beschrieben. Die lichtabsorbierend beschichtete Paillette 140 ist im Ergebnis lichtundurchlässig.

Eine solche Ausführungsform eines Folienverbundes 100⁗ ist somit besonders vorteilhaft im Zusammenhang mit einem modulunterbrochenen Solarglasverbund 950‴ geeignet, weil durch eine lichtdurchlässige Hintergrundscheibe 220 ein von der Innenseite 80 und in den modulfreien Bereichen 920 - durchschaubarer Gesamtaufbau entsteht. Ein modulunterbrochener Solarglasverbund 950⁗ weist mindestens einen modulfreien Bereich 920 auf, in dem eine oder mehrere lichtabsorbierend beschichtete Pailletten 140 angeordnet sind. Gleichwohl ist in der in Fig. 4B gezeigten Ausführungsform der Einsatz einer lichtundurchlässigen Hintergrundscheibe 220 möglich.

Ein Solarglasverbund 950, 950‘, 950", 950‴ ist vorteilhaft relativ unabhängig von einer Träger- bzw. Untergrundfläche und kann als - bevorzugt selbsttragendes - flächiges Bauelement in einen Rahmen oder dergleichen mechanische Tragstruktur befestigt werden, weil er aufgrund der lichtdurchlässigen Scheibe 200 und der Hintergrundscheibe 220 bzw. des Solarmoduls 700 einen erhöhten Grad an Eigenstabilität aufweist. Ein Solarglasverbund 950, 950', 950", 950''' weist insbesondere eine ausreichende mechanische Stabilität auf, um beispielsweise als selbstständiges Dach-und/oder Fassadenelement, ohne weitere stabilisierende Tragstruktur, beispielsweise als Dachelement für einen Wintergarten oder ein Carport, verwendet zu werden.

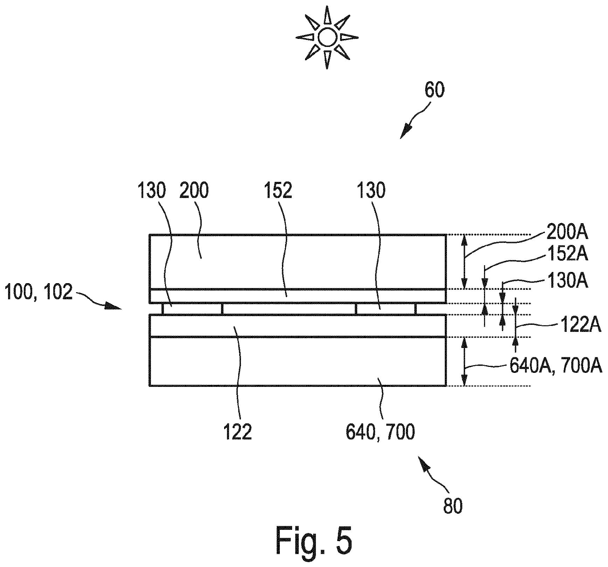

Fig. 5 zeigt den Schichtaufbau eines Folienverbundes 100 unter Angabe der Stärken der einzelnen Folien bzw. Schichten.

Der Folienverbund 100 ist zwischen einer auf der Außenseite 60 angeordneten lichtdurchlässigen Scheibe 200 mit einer Scheibenstärke 200 A und einem oder mehreren auf einer Innenseite 80 angeordneten Solarmodulen 700 mit einer Modulstärke 700A angeordnet. Bei Ausführungsformen mit mehreren Solarmodulen 700 sind diese insbesondere nebeneinander in einer Ebene angeordnet.

Die Scheibenstärke 200A kann insbesondere einen Wert zwischen 1,5 mm und 19 mm annehmen.

Die Modulstärke 700A der Solarmodule 700 kann insbesondere einen Wert zwischen 0,5 mm und 20 mm, bevorzugt zwischen 1 mm und 10 mm, annehmen. Bei der Gestaltung eines anderen Folienverbundes 102 einer Alternative der Erfindung im Zusammenhang mit einer transmissionssenkenden Scheibe 640 kann die transmissionssenkende Scheibe 640 eine Stärke 640A aufweisen, die insbesondere zwischen 1 mm und 20 mm liegt.

Die Deck-Laminierfolie 152 weist eine Deck-Laminierfolienstärke 152A auf. Die Träger-Laminierfolie 122 weist eine Träger-Laminierfolienstärke 122A auf. Die Deck-Laminierfolienstärke 152A und/oder die Träger-Laminierfolienstärke 122A beträgt zwischen 0,2 mm und 3 mm, bevorzugt zwischen 0,5 mm und 1 mm, besonders bevorzugt zwischen 0,7 mm und 0,8 mm. Die Deck-Laminierfolienstärke 152A und/oder die Träger-Laminierfolienstärke 122A kann beispielsweise 0,76 mm, in anderen Ausführungsformen 0,38 mm betragen. Die Pailletten 130 weisen eine Paillettenstärke 130A auf, welche je nach Schichtaufbau der Paillette 130 variieren kann und bevorzugt zwischen 23 $\mu$m und 500 $\mu$m, bevorzugt zwischen 75 $\mu$m und 350 $\mu$m, besonders bevorzugt zwischen 100 $\mu$m und 250 $\mu$m liegen kann.

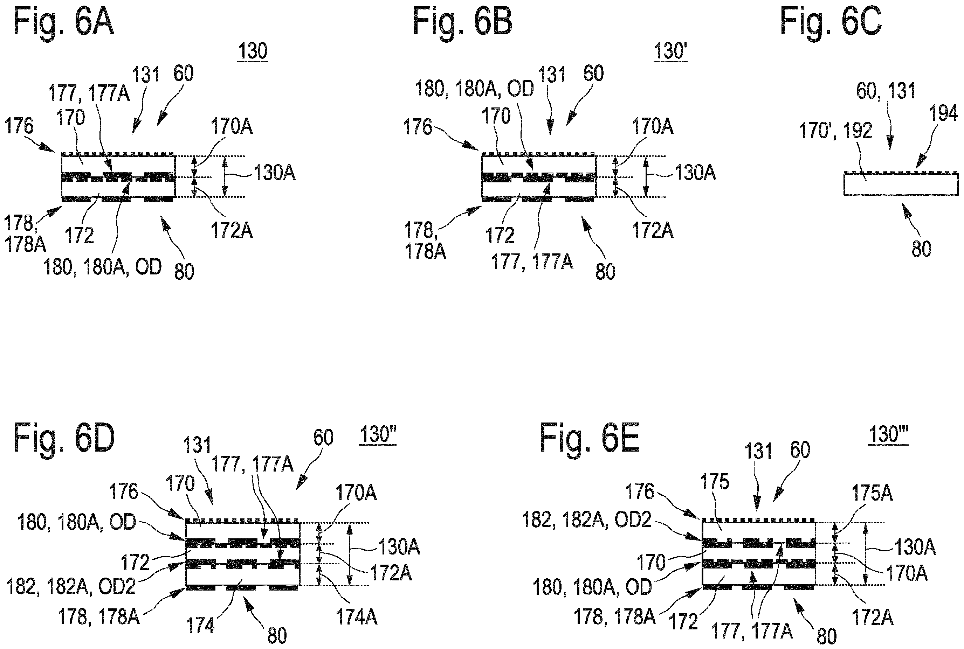

Fig. 6A bis Fig. 6G zeigen unterschiedliche Pailletten 130, 140, welche im Rahmen der Erfindung eingesetzt und insbesondere auch beliebig miteinander auf einem Folienverbund kombiniert werden können. Auch können einzelne Bestandteile einzelner Pailletten 130, 140 mit Bestandteilen anderer gezeigter Pailletten 130, 140 kombiniert werden. Diese Kombinierbarkeit trifft insbesondere auf unterschiedliche Paillettenträgerfolien 172 und Paillettendeckfolien 170 zu.

Fig. 6A zeigt in einer Querschnittsansicht schematisch den Aufbau einer Paillette 130. Eine Paillettenträgerfolie 172 ist auf einer der Innenseite 80 zugewandten Seite der Paillette 130 - das heißt einer der Sichtseite 131 abgewandten Seite der Paillette 130 - angeordnet. Die Paillettenträgerfolie 172 weist eine Paillettenträgerfolienstärke 172A auf. Die Paillettenträgerfolienstärke 172A kann in sämtlichen Ausführungsformen einen Wert zwischen 15 $\mu$m und 150 $\mu$m annehmen.

Auf der der Außenseite 60 zugewandten Seite der Paillettenträgerfolie 172, das heißt auf der Sichtseite 131, weist die Paillettenträgerfolie 172 eine, insbesondere metallische, Beschichtung 180 mit einer optischen Dichte OD auf. Die Beschichtung 180 kann eine Beschichtungsstärke 180A im Nanometerbereich, insbesondere kleiner 30 nm annehmen. Die Paillettenträgerfolie 172 und die Paillettendeckfolie 170 sind lichtdurchlässig, insbesondere derart, dass die optische Dichte OD im Wesentlichen allein über die Beschichtung 180 eingestellt werden kann.

Auf einer der Innenseite 80 - und somit der Träger-Laminierfolie 122 oder der Zwischen-Trägerfolie 124 - zugewandten Seite der Paillettenträgerfolie 172, insbesondere der Paillettendeckfolie 170 abgewandten Seite der Paillettenträgerfolie 172, kann in sämtlichen Ausführungsformen optional ein Fixierklebstoff 178 aufgebracht sein, um die Paillette 130 auf dem Folienverbund 100, insbesondere auf der Träger-Laminierfolie 122 zu fixieren. Der Fixierklebstoff 178 kann insbesondere aus einem thermoplastischen Adhäsiv oder dergleichen, für Kunststoffe geeigneten Klebstoff, gebildet sein und kann bevorzugt mit einer Fixierklebstoffstärke 178A von 20 $\mu$m bis 60 $\mu$m aufgetragen werden.

Pailletten 130, 140 in sämtlichen Ausführungsformen der Erfindung können optional zwischen der Paillettenträgerfolie 172 und der Paillettendeckfolie 170, und/oder zwischen zwei oder mehreren Paillettenträgerfolien 172 und/oder zwischen zwei oder mehreren Paillettendeckfolien 170, einen Paillettenklebstoff 177, mit einer Paillettenklebstoffstärke 177A, aufweisen. Die Paillettenklebstoffstärke 177A beträgt insbesondere zwischen 20 $\mu$m und 60 $\mu$m.

Auf einer der Außenseite 60 - und somit der Deck-Laminierfolien 152 oder der Zwischen-Deckfolie 126 -zugewandten Seite der Paillette 130, bzw. der Sichtseite 131, ist eine Paillettendeckfolie 170 angeordnet. Die Paillettendeckfolie 170 bedeckt und schützt die Beschichtung 180 der Paillettenträgerfolie 172. Die Paillettendeckfolie 170 weist eine Paillettendeckfolienstärke 170A auf. Die Paillettendeckfolienstärke 170A kann in sämtlichen Ausführungsformen einen Wert zwischen 15 $\mu$m und 150 $\mu$m annehmen. Die Paillettendeckfolie 170 kann in sämtlichen Ausführungsformen auf ihrer der Außenseite 60 zugewandten Seite optional eine haftungsoptimierte Oberfläche 176 aufweisen. Die haftungsoptimierte Oberfläche 176 kann insbesondere durch eine Plasmabehandlung erzeugt werden. Die Paillettenträgerfolie 172 kann mit der Paillettendeckfolie 170 und/oder möglichen weiteren Paillettenträgerfolien 174 mittels des Fixierklebstoffs 178 oder dergleichen, für Kunststoffe geeigneten Adhäsiv verbunden werden.

Die Paillettenstärke 130A setzt sich somit aus den Schichtstärken der einzelnen Bestandteile der Paillette 130 zusammen, in dem in Fig. 6A gezeigten Fall also aus der Fixierklebstoffstärke 178A, der Paillettenträgerfolienstärke 172A, der Beschichtungsstärke 180A, der Paillettenklebstoffstärke 177A und der Paillettendeckfolienstärke 170A.

Eine Paillette 130 hat in der Regel einen scheibenförmigen, planen Aufbau für eine vorteilhafte Integration in das Laminat des Folienverbundes 100. Eine Paillette 130 kann allgemein aber auch eine Wölbung oder Rundungen aufweisen, sodass beispielsweise auf einer oder beiden Seiten der Paillette 130 eine konkave oder eine konvexe Oberfläche entsteht (nicht gezeigt).

Fig. 6B zeigt eine Ausführungsform einer Paillette 130', bei der im Unterschied zu der in Fig. 6A gezeigten Paillette 130 die Beschichtung 180 auf der Paillettendeckfolie 170 angeordnet ist.

Fig. 6C zeigt eine besondere Ausführung einer Paillettendeckfolie 170', die als eine Dekorfolie 192 ausgebildet ist. Eine solche als Dekorfolie 192 ausgebildete Paillettendeckfolie 170' kann in sämtlichen hier in den Fig. 6A bis Fig. 6G gezeigten Pailletten 130, 140, anstelle einer Paillettendeckfolie 170 oder zusätzlich zu einer Paillettendeckfolie 170, eingesetzt werden. Eine als Dekorfolie 192 ausgebildete Paillettendeckfolie 170' kann aus einem gefärbten Material gebildet sein und/oder mit einer Farbschicht 194 versehen sein. Die Farbschicht 194 kann aufgedruckt oder lackiert sein. Die Farbschicht 194 ist insbesondere auf der Sichtseite 131 einer Paillette 130,140, das heißt einer der Außenseite 60 zugewandten Seite, aufgebracht. In alternativen Ausführungsformen kann die Farbschicht 194 auch der der Sichtseite 131 gegenüberliegenden Seite einer Paillette 130,140, das heißt einer der Innenseite 80 zugewandten Seite, aufgebracht sein.

Fig. 6D zeigt eine Ausführungsform einer Paillette 130", die zusätzlich zu der in Fig. 6A gezeigten Paillette 130 auf einer der Innenseite 80 zugewandten Seite eine weitere Paillettenträgerfolie 174 aufweist. Die weitere Paillettenträgerfolie 174 bildet somit eine weitere zur Innenseite 80 liegende Schicht der Paillette 130" und weist daher auf ihrer zur Innenseite 80 gerichteten Seite den Fixierklebstoff 178 auf. Auf ihrer zur Außenseite 60 gerichteten Seite weist die weitere Paillettenträgerfolie 174 eine weitere, insbesondere metallische, Beschichtung 182 auf, mit einer weiteren Beschichtungsstärke 182A und einer weiteren optischen Dichte OD2. Die weitere Beschichtung 182 kann dabei aus einem anderen metallischen Material als die Beschichtung 180 gebildet sein. Insbesondere können unterschiedliche Beschichtungsmaterialien zum Erzeugen unterschiedlicher Reflexionseffekte, insbesondere mit unterschiedlichen Farben, eingesetzt werden. Auch kann somit die weitere optische Dichte OD2 von der optischen Dichte OD abweichen. Die Paillettenträgerfolien 172, 174 und die Paillettendeckfolie 170 sind jeweils über eine Schicht Paillettenklebstoff 177 miteinander verbunden. Eine Paillette 130" kann in anderen Ausführungsformen noch weitere, in analoger Weise hinzugefügte, Paillettenträgerfolien 172, 174 aufweisen.

Fig. 6E zeigt eine Ausführungsform einer Paillette 130''', die zusätzlich zu der in Fig. 6A gezeigten Paillette 130 auf einer der Außenseite 60 zugewandten Seite eine weitere Paillettendeckfolie 175 aufweist. Auch sind bei der Paillette 130''' im Unterschied zu den in Fig. 6A und 6D gezeigten Pailletten 130, 130" die Beschichtungen 180, 182 nicht auf der Paillettenträgerfolie 172, sondern auf den Paillettendeckfolien 170, 175 aufgebracht. Eine Beschichtung 180 mit einer optischen Dichte OD ist auf der Paillettendeckfolie 170, eine weitere Beschichtung 182 mit einer weiteren optischen Dichte OD2 auf der weiteren Paillettendeckfolie 175 angeordnet. Die Paillettenträgerfolie 172 und die Paillettendeckfolien 170, 175 sind jeweils über eine Schicht Paillettenklebstoff 177 miteinander verbunden. Eine Paillette 130''' kann in anderen Ausführungsformen noch weitere, in analoger Weise hinzugefügte, Paillettendeckfolien 170, 175 aufweisen.

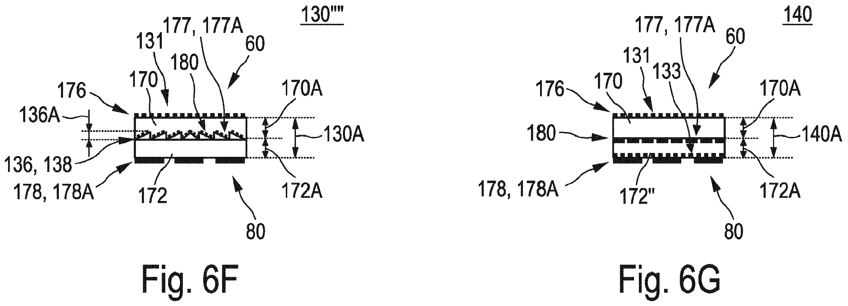

Fig. 6F zeigt eine Ausführungsform einer Paillette 130'''' die, insbesondere im Unterschied zu der in Fig. 6A gezeigten Paillette 130, auf der der Außenseite 60 zugewandten Seite der Paillettenträgerfolie 172 eine Oberflächenstrukturierung 136, insbesondere eine Prägung, aufweist. Die Oberflächenstrukturierung 136 kann insbesondere als Mikrospiegelanordnung 138 ausgebildet sein. Die Oberflächenstrukturierung weist eine Strukturtiefe 136A zwischen der niedrigsten und der höchsten Stelle der Oberflächenstrukturierung im Sinne eines Peak-to-Valley-Wertes auf, welcher bevorzugt kleiner als 30 $\mu$m, besonders bevorzugt kleiner als 10 $\mu$m ist. Die - insbesondere metallische - Beschichtung 180 der Paillettenträgerfolie 172 ist auf die Oberflächenstrukturierung 136 aufgebracht, und wird - analog zu den vorausgehend gezeigten Ausführungsformen - von der Paillettendeckfolie 170 bedeckt. Als Material für die Beschichtung 180 oder die weitere Beschichtung 182 sind insbesondere Chrom, Aluminium, Kupfer, Titannitrid sowie Aluminium-Kupfer-Legierungen und/oder Siliziumdioxid ($SiO_2$) geeignet.

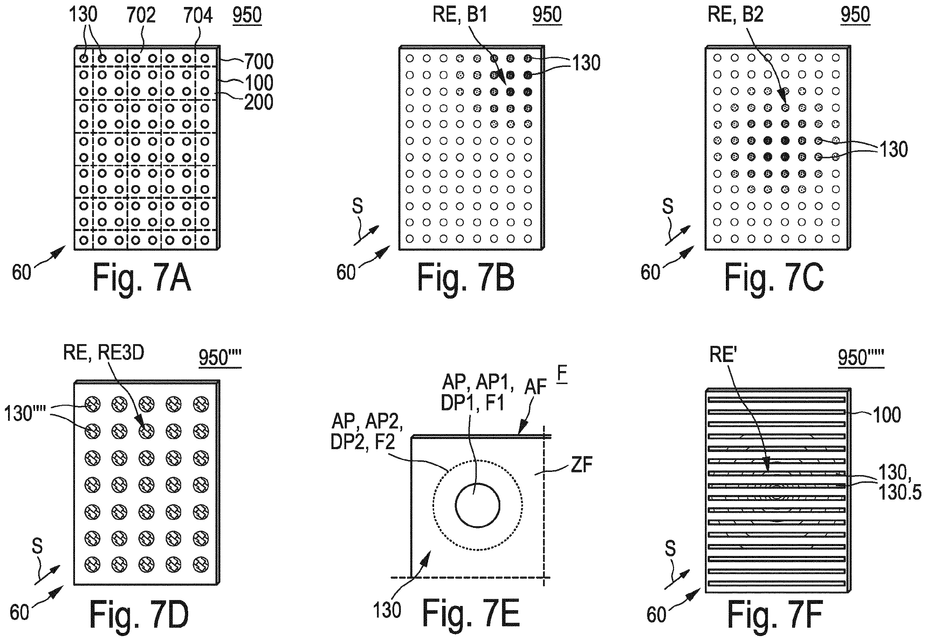

Durch die Oberflächenstrukturierung 136, insbesondere durch die Mikrospiegelanordnung 138, wird im Zusammenhang mit der metallischen Beschichtung 180 erreicht, dass der Reflexionseffekt RE, welcher durch das teilweise Reflektieren der von der Außenseite 60 auf die Paillette 130'''' einfallenden Lichtstrahlung S entsteht, in besonderer Weise ausgebildet ist. Durch eine Oberflächenstrukturierung 136, insbesondere eine Mikrospiegelanordnung 138, wie z.B. eine oder mehrere Fresnel-Linsen, können optische Effekte in Form eines dreidimensionalen Reflexionseffekts RE3D, beispielsweise Wellenformen, geometrische Formen, konkave oder konvexe Wölbungen und dergleichen Prägemuster, erzeugt werden, welche in der Wahrnehmung eines Betrachters eine wesentlich größere Tiefenwirkung suggerieren, die insbesondere ein Vielfaches über die tatsächliche Höhe 136A der Oberflächenstrukturierung 136 hinausgehen (sh. auch Fig. 7D). Die Paillettenträgerfolie 172 und die Paillettendeckfolie 170 sind über eine Schicht Paillettenklebstoff 177 miteinander verbunden.

Fig. 6G zeigt schematisch eine Abwandlung einer Ausführungsform einer Paillette 140. Diese unterscheidet sich insbesondere von der in Fig. 6A gezeigten Paillette 130 dadurch, dass ihre Paillettenträgerfolie 172" auf Ihrer der Innenseite 80 zugewandten Seite zusätzlich eine lichtabsorbierende Beschichtung 133 aufweist. Die lichtabsorbierende Beschichtung 133 kann insbesondere als eine schwarze Bedruckung oder eine schwarze Lackierung ausgebildet sein. Durch die lichtabsorbierende Beschichtung 133 ist die Paillette 140 im Ergebnis lichtundurchlässig.

Sämtliche Pailletten 130, 130', 130", 130''', 130"", 140 können auf ihrer der Außenseite 60 zugewandten Seite optional eine haftungsoptimierte Oberfläche 176 aufweisen.

Fig. 7A, Fig. 7B und Fig. 7C zeigen schematisch einen Solarglasverbund 950 zur Verdeutlichung der Erzeugung eines Reflexionseffekts RE. In Fig. 7A ist ein Solarglasverbund 950 schemenhaft und ohne einfallende Lichtstrahlung S von einer Außenseite 60 gezeigt. Hinter einer zur Außenseite 60 gerichteten und lichtdurchlässigen Scheibe 200 ist ein Folienverbund 100 gemäß dem Konzept der Erfindung mit einer Anzahl an Pailletten 130 angeordnet. Dahinterliegend ist ein Solarmodul 700 angeordnet, von dem in Fig. 7A die Moduloberfläche 702 mit charakteristischen Modulstrukturen 704 sichtbar sind. Derartige Modulstrukturen 704 können insbesondere durch Kontaktierungen, Lötbändchen, Rahmen, Verbindungen und/oder Leitungen gebildet sein. Derartige charakteristische Modulstrukturen 704 eines Solarmoduls 700 können einen visuellen Einfluss auf den Gesamteindruck eines Gebäudes haben, welcher gemäß dem Konzept der Erfindung vorteilhaft reduziert oder sogar eliminiert werden soll. Die Moduloberfläche 702 ist insbesondere dunkel, beispielsweise schwarz oder dunkelblau, ausgebildet. Insbesondere weist eine Moduloberfläche 702 eine geringe Reflexion, beispielsweise von 2-3 % auf und ist stark absorbierend ausgebildet, zum Erreichen einer möglichst großen Energieausbeute E. Durch eine dunkle Moduloberfläche 702 wird der Kontrast zu den Pailletten 130 zum Erreichen eines visuellen Kaschierens vorteilhaft noch verbessert.

In Fig. 7B wird der Solarglasverbund 950 bei einer von der Außenseite 60 einfallenden Lichtstrahlung S von einer ersten Blickrichtung B1 dargestellt. Durch die Pailletten 130, welche aufgrund ihrer metallischen Beschichtung 180 die einfallende Lichtstrahlung S zu einem bestimmten Grad reflektieren, wird ein Reflexionseffekt RE erzeugt. Dieser Reflexionseffekt RE kann sich insbesondere in Form eines Schimmerns, Glänzens und/oder eines über den Solarglasverbund 950 verlaufenden Helligkeits- und/oder Farbgradienten äußern. Insbesondere entsteht - eine mit der Blickrichtung B wechselnde Erscheinung des Reflexionseffekts RE. Das heißt, dass in Abhängigkeit des Standpunkts des Betrachters vor einem Solarglasverbund 950oder einer Anzahl von Solarglasverbünden 950, der Reflexionseffekt RE variiert und somit eine "lebendige" Oberfläche entsteht. Dies ist beispielhaft in Fig. 7C gezeigt, wo der Reflexionseffekt RE von einer zweiten Blickrichtung B2, das heißt von einem anderen Standort des Betrachters, gezeigt ist. Im Unterschied zu dem hier vereinfacht stetig verlaufend gezeigten Reflexionseffekt RE kann der Reflexionseffekt RE weiter verfremdet erscheinen, insbesondere durch eine geringfügig unterschiedliche Anordnung der einzelnen Pailletten und/oder den Einsatz unterschiedlich ausgebildeter, beispielsweise unterschiedlich großer, Pailletten im Folienverbund.

Der Reflexionseffekt RE lässt das dahinterliegende Solarmodul 700, insbesondere die dahinterliegende Moduloberfläche 702 und die Modulstrukturen 704, für einen Betrachter teilweise oder vollständig in den Hintergrund treten. Generell gilt, dass ein größerer Flächenbedeckungsgrad F und/oder eine größere optische Dichte OD der Pailletten 130 und/oder ein höherer Kontrast - zwischen den in der Regel hellen Beschichtungen 180 der Pailletten 130 und der in der Regel dunklen Moduloberfläche 702 - zu einem stärkeren wahrnehmbaren Reflexionseffekt RE führt, was vorteilhaft für die visuelle Kaschierung des Solarmoduls 700 ist.

Gleichzeitig führt ein geringerer Flächenbedeckungsgrad F und/oder eine geringere optische Dichte OD der Pailletten 130 zu einer höheren Energieausbeute E des Solarmoduls 700. Daher ist bei der Gestaltung des Folienverbundes 100 im Zusammenhang mit einem Solarmodul 700 der Flächenbedeckungsgrad F und die optische Dichte OD bevorzugt so zu wählen, dass ein Optimum erreicht wird zwischen einer ausreichenden visuellen Kaschierung und gleichzeitig einer möglichst großen Energieausbeute E des Solarmoduls 700.

Dahingegen ist bei der Gestaltung eines anderen Folienverbundes 102 einer Alternative der Erfindung im Zusammenhang mit einer transmissionssenkenden Scheibe 640 der Flächenbedeckungsgrad F bevorzugt höher zu wählen, sodass - im Sinne eines effektiven Sonnenschutzes - ein möglichst geringer transmittierter Anteil T der einfallenden Lichtstrahlung durch den Folienverbund tritt. Die optische Dichte OD kann entsprechend angepasst, insbesondere niedriger gewählt werden, um den visuellen Eindruck der Pailletten, insbesondere von einer Innenseite 80 durch die transmissionssenkende Scheibe 640 betrachtet, trotz des erhöhten Flächenbedeckungsgrades F nicht zu stark werden zu lassen. Gleichwohl muss die optische Dichte stets ausreichend hoch gewählt werden, um noch einen Reflexionseffekt erzeugen zu können. Auch kann die optische Dichte OD zum Erreichen eines effektiven Sonnenschutzes, insbesondere höher, gewählt werden, auch weil der visuelle Eindruck einer teilreflektierenden Paillette stets geringer ist als bei einer, beispielsweise aus WO 2019/038288 A1 bekannten, lichtundurchlässigen, insbesondere vollreflektieren, Paillette.

Fig. 7D zeigt eine Ausführungsform eines Solarglasverbunds 950"", die einen Folienverbund 100 mit wie in Fig. 6F gezeigten Pailletten 130'''' aufweist. Diese Pailletten 130'''' weisen Oberflächenstrukturierungen 136 (siehe Fig. 6F) auf, welche ausgebildet sind, bei einfallender Lichtstrahlung S einen als dreidimensionalen Reflexionseffekt RE3D ausgebildeten Reflexionseffekt RE zu erzeugen. Der dreidimensionale Reflexionseffekt RE3D kann sich insbesondere mit dem in Fig. 7B und Fig. 7C gezeigten Reflexionseffekt RE überlagern. Eine Überlagerung kann insbesondere derart sein, dass bei näherem Betrachten der Solarmodulanordnung, beispielsweise wenn der Betrachter in einem Abstand von 1 m oder weniger entfernt ist, die durch die Oberflächenstrukturierung 136 erzeugten dreidimensionalen Strukturen als solche erkannt werden, von einer größeren Entfernung jedoch lediglich ein allgemeiner Reflexionseffekt RE, beispielsweise in Form eines Schimmerns oder Glänzens, sichtbar ist.

Fig. 7E zeigt beispielhaft zwei unterschiedliche Flächenbedeckungsgrade F. Aufgrund der typischerweise wiederholten, musterartigen Anordnung der Pailletten 130 im Folienverbund 100 ist hier zur Verdeutlichung lediglich ein Ausschnitt mit einer Paillette 130 gezeigt. Der Flächenbedeckungsgrad F ist dabei der Quotient aus der Paillettenfläche AP und der gesamten Folienfläche AF. In dem theoretischen Fall, dass die gesamte Fläche des Folienverbundes 100, das heißt die Folienfläche AF, mit Pailletten 130 bedeckt wäre, würde somit ein Flächenbedeckungsgrad F von 1 entstehen. Vorliegend wird verdeutlicht, dass eine Paillette 130 mit einem kleineren Paillettendurchmesser DP1 und dementsprechend einer kleineren ersten Paillettenfläche AP1 in einem geringeren ersten Flächenbedeckungsgrad F1 resultiert. Eine Paillette 130 mit einem größeren Paillettendurchmesser DP2 und entsprechend einer größeren zweiten Paillettenfläche AP2 resultiert demzufolge in einem höheren zweiten Flächenbedeckungsgrad F2. Der von Pailletten 130 freie Teil der Folienfläche AF wird durch eine Zwischenfläche ZF beschrieben. Die Größe der Zwischenfläche ZF nimmt mit steigendem Flächenbedeckungsgrad F ab.

Fig. 7F zeigt als weitere Beispiel eine Vorderansicht eines weiteren bevorzugten Ausführungsbeispiels eines Solarglasverbundes 950″″ mit einem Folienverbund 100 gemäß dem Konzept der Erfindung, aufweisend Pailletten 130 mit einer streifenförmigen Flächenform 130.5.

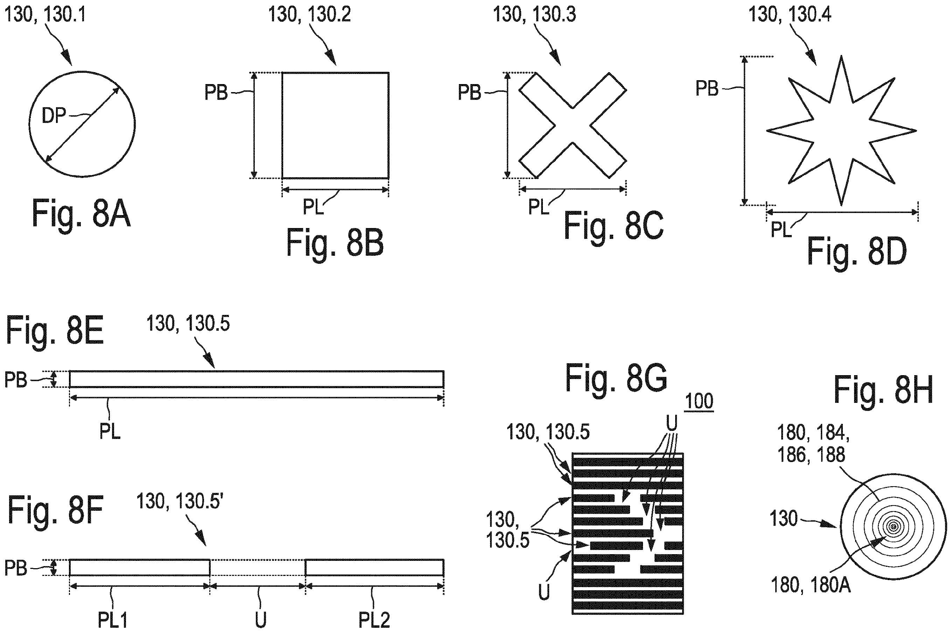

Die Fig. 8A bis Fig. 8H zeigen unterschiedliche mögliche Flächenformen 130.1-5 von Pailletten 130 jeweils in einer Draufsicht, das heißt mit der Zeichenebene parallel zu einem (hier nicht dargestellten) Folienverbund. Dabei zeigt Fig. 8A eine erste, runde Flächenform 130.1 einer Paillette 130 mit einem Paillettendurchmesser DP. Bei den ab Fig. 8B folgenden Pailletten ist schematisch eine Paillettenbreite PB und eine Paillettenlänge PL eingezeichnet. Fig. 8B zeigt eine zweite, quadratische Flächenform 130.2 einer Paillette 130. Gleichwohl sind natürlich auch andere geometrische Formen wie rechteckige, trapezförmige oder n-eckige Formen möglich. Fig. 8C zeigt eine Paillette mit einer dritten, kreuzförmigen Flächenform 130.3. Fig. 8D zeigt eine vierte, sternförmige Flächenform 130.4. Fig. 8E zeigt eine fünfte, streifenförmige Flächenform 130.5. Eine Paillette 130 mit einer streifenförmigen Flächenform 130.5 kann relativ geringe Paillettenbreite PB, beispielsweise von wenigen Zentimetern oder Millimetern, und eine relativ große Paillettenlänge PL, beispielsweise von mehreren Dezimetern bis Metern, aufweisen. Die Paillettenlänge PL kann insbesondere derart ausgebildet sein, dass sich eine Paillette 130 über die gesamte Fläche eines Solarmoduls 700 und/oder eines Solarglasverbunds 950 erstreckt. In Fig. 8F ist eine Abwandlung der in Fig. 8E gezeigten streifenförmigen Flächenform 130.5 in Form einer unterbrochenen streifenförmigen Flächenform 130.5' gezeigt, in der die Paillette 130 eine oder mehrere Unterbrechungen U aufweist, die die Paillette 130 in mehrere Teile aufteilt, hier einen ersten Teil mit einer ersten Paillettenlänge PL1 und einen zweiten Teil mit einer zweiten Paillettenlänge PL2. In Fig. 8G ist beispielhaft ein Folienverbund 100 gezeigt, der sowohl Pailletten 130 mit einer streifenförmigen Flächenform 130.5 aufweist, als auch Pailletten mit einer unterbrochenen streifenförmigen Flächenform 130.5', wobei vorliegend die Pailletten 130 mit einer unterbrochenen streifenförmigen Flächenform 130.5' eine oder mehrere Unterbrechungen U aufweisen, in denen kein Material der Paillette 130 vorhanden ist.

Trotz der hier in Fig. 8E, Fig. 8F und Fig. 8G dargestellten, horizontalen Ausrichtung können Pailletten 130 mit streifenförmige Flächenform 130.5, wie auch andere Pailletten, in einer anderen Ausrichtung, insbesondere vertikal oder in einem Winkel verlaufend, in einem Folienverbund angeordnet werden.

Gleichwohl sind weitere Flächenformen einer Paillette 130 möglich. Auch die Ausrichtung, das heißt die Drehung der Paillette in der Zeichenebene, kann variiert werden. Beispielsweise kann das in Fig. 8B gezeigte Quadrat durch Drehung um 45° als eine Raute auf dem Folienverbund angeordnet werden. Auch ist eine Kombination von Pailletten 130 mit unterschiedlichen Flächenformen auf einem Folienverbund 100 möglich.

Fig. 8H zeigt eine veränderliche Beschichtung 184, hier in Form einer lateral variierenden Beschichtung 186. Die Beschichtungsstärke 180A ist dabei lateral veränderlich ausgebildet und verändert sich über den Verlauf der Oberfläche der Paillette 130. Im vorliegenden Fall ist diese Veränderung stetig, weshalb eine Gradienten-Beschichtung 188 vorliegt. Die Gradienten-Beschichtung 188 ist vorliegend derart, dass in der Mitte der Oberfläche der Paillette 130 eine höhere Beschichtungsstärke 180A vorliegt, die radial stetig nach außen geringer wird. Eine veränderliche Beschichtung 184 kann selbstverständlich auch auf andere Pailletten 130, insbesondere andere Flächenformen, übertragen werden.

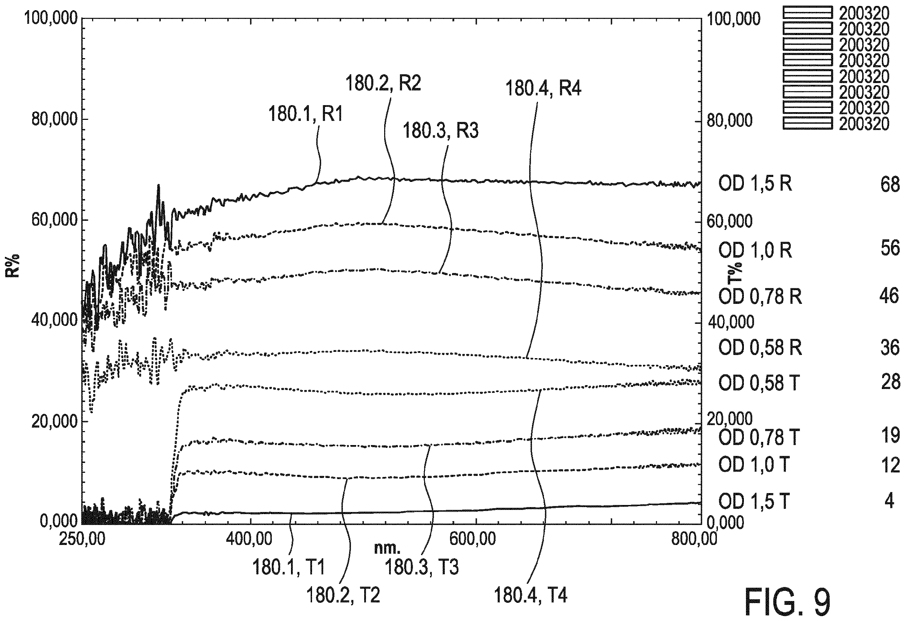

Fig. 9 zeigt die Transmissionseigenschaften von vier verschiedenen Beschichtungen 180.1, 180.2, 180.3, 180.4 für eine Paillette 130 in Abhängigkeit der Lichtwellenlänge. Jede der gezeigten Beschichtungen ist eine metallische Beschichtung, nämlich eine Chrom-Beschichtung, welche jeweils auf eine PET-Folie als Paillettenträgerfolie aufgebracht wurde. Das Beschichten kann über ein Vakuumbeschichtungsverfahren, insbesondere mittels physikalischer Gasphasenabscheidung (PVD), Verdampfen, Sputtern und/oder einem Kathodenzerstäubungsverfahren, oder dergleichen Beschichtungsverfahren erfolgen.

Die unterschiedlichen optischen Dichten OD werden dabei durch unterschiedliche Beschichtungsstärken 180A.1-4 hervorgerufen. Dabei gilt der Zusammenhang, dass je geringer eine Beschichtungsstärke 180A ist, desto geringer die optische Dichte OD. Je geringer die optische Dichte OD ist, desto größer ist der Anteil an transmittierter Lichtstrahlung T und desto geringer der Anteil an reflektierter Lichtstrahlung R.

Für jede Beschichtung ist vorliegend der prozentuale Wert der transmittierten Lichtstrahlung T und der reflektierten Lichtstrahlung R in Abhängigkeit der Lichtwellenlänge aufgetragen. Die Summe von transmittierter Lichtstrahlung T und reflektierter Lichtstrahlung R nimmt einen Wert kleiner 100 % an, insbesondere, weil ein Anteil der einfallenden Lichtstrahlung S absorbiert wird, insbesondere in der Beschichtung.

Es ist eine erste Beschichtung 180.1 mit einer optischen Dichte OD von 1,5 mit einer ersten transmittierten Lichtstrahlung T1 und einer ersten reflektierten Lichtstrahlung R1 gezeigt. Durch die relativ hohe optische Dichte OD und somit relativ geringe Lichtdurchlässigkeit resultiert ein relativ hoher Anteil an reflektierter Lichtstrahlung R1 und entsprechend relativ geringer Anteil an transmittierter Lichtstrahlung T1. Weiter ist eine vierte Beschichtung 180.4 mit einer optischen Dichte OD von 0,58 mit einer vierten transmittierten Lichtstrahlung T4 und einer vierten reflektierten Lichtstrahlung R4 gezeigt. Durch die relativ geringe optische Dichte OD und somit relativ hohe Lichtdurchlässigkeit resultiert ein relativ geringer Anteil an reflektierter Lichtstrahlung R4 und entsprechend relativ hoher Anteil an transmittierter Lichtstrahlung T4.

Bei der Verwendung von anderen Metallen als Beschichtungsmaterial kann die Beschichtungsstärke zum Erreichen eines vergleichbaren Anteils an transmittierter Lichtstrahlung T unterschiedlich sein, wobei stets der Zusammenhang gilt, dass bei einer größeren Beschichtungsstärke 180A eine größere optische Dichte OD resultiert.

Die optische Dichte OD lässt sich generell aus der transmittierten Lichtstrahlung T wie folgt bestimmen:

$$OD = - \log (T)$$

Des Weiteren lassen sich im Rahmen der Erfindung durch geringere Schichtdicken noch niedrigere Werte für die optische Dichte OD erzielen, wobei nachfolgend beispielhaft gemessene Werte für eine transmittierte Lichtstrahlung T dargestellt sind, welche bei einer - für den sichtbaren Wellenlängenbereich charakteristischen - Wellenlänge von 550 nm gemessen wurden. Auch bei diesen Werten handelt es sich - wie auch bei den oben beschriebenen Werten aus Fig. 9 - um eine Chrombeschichtung auf einer PET-Folie.

| Beschichtungsstärke [nm] | OD | T [%] |
|---|---|---|
| 13 | 0,55 | 28 |
| 8 | 0,31 | 49 |
| 4 | 0,21 | 61 |
| 2,5 | 0,12 | 74,5 |
| 2 | 0,07 | 85 |

Selbst bei einer Transmission, das heißt eines Anteils des transmittierten Lichts T von 85 %, also hier einer Beschichtungsstärke von 2 nm, kann noch eine Reflexion auf der Beschichtungsoberfläche erzeugt werden, welche zum visuellen Kaschieren eines Solarmoduls ausreicht. Insbesondere kann bei einem hohen Anteil von transmittiertem Licht, beispielsweise T > 75 % und entsprechend optischen Dichten OD kleiner als 0,12, ausgleichend ein entsprechend größerer Flächenbedeckungsgrad gewählt werden, beispielsweise F > 0,5, um noch einen ausreichenden Reflexionseffekt RE zu erzielen.

Nachstehend sind für die drei verschiedenen Beschichtungsmaterialien Chrom, Aluminium und Kupfer Transmissions- und Reflexionswerte in Abhängigkeit der optischen Dichte aufgeführt.

| OD | Transmission | Reflexion (Cr) | Reflexion (Al) | Reflexion (Cu) |
|---|---|---|---|---|
| 0,1 | 79% | Ca. 2% | Ca. 7% | Ca. 2% |
| 0,2 | 63% | Ca. 5% | Ca. 19% | Ca. 8% |
| 0,3 | 50% | Ca. 10% | Ca. 31% | Ca. 13% |
| 0,4 | 40% | Ca. 16% | Ca. 40% | Ca. 20% |
| 0,5 | 31% | Ca. 23% | Ca. 49% | Ca. 28% |

Aluminium weist dabei im Vergleich Kupfer und Chrom bei gleicher Transmission vorteilhaft hohe Reflexionswerte auf, was vorteilhaft zum Erzeugen eines Reflexionseffekts ist.

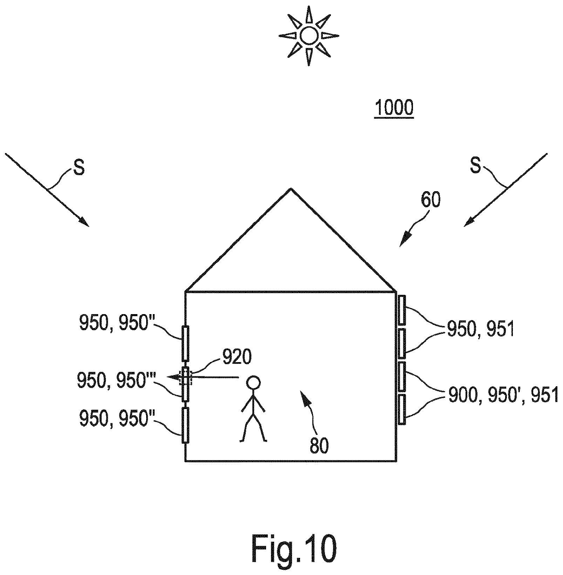

Fig. 10 zeigt ein Gebäude 1000 mit unterschiedlichen, beliebig kombinierbaren Modulen, wobei die einzelnen Module einen Folienverbund gemäß dem Konzept der Erfindung aufweisen.

An dem Gebäude 1000 sind zwei Solarverbundgläser 950 mit einem in Fig. 3A gezeigten Aufbau angeordnet. Am Gebäude 1000 sind weiter zwei Solarverbundgläser 950' mit einem in Fig. 3B gezeigten Aufbau angeordnet, welche folglich jeweils ein Gebäudeverkleidungselement 900 aufweisen.

In der Alternative der Erfindung können die genannten Module jeweils auch als Sonnenschutzglasverbund 951 ausgebildet sein und dann insbesondere von der Innenseite 80 zur Außenseite 60 durchschaubar ausgebildet sein.

Das Gebäude 1000 weist drei weitere Solarverbundgläser 950 auf, von denen zwei als Solarverbundgläser 950" - mit in einen Folienverbund 100‴ einlaminierten Solarmodulen 700 - ausgebildet sind und eines als modulunterbrochenes Solarverbundglas 950‴. Das modulunterbrochene Solarverbundglas 950‴ weist einen Folienverbund 100‴' auf und kann dadurch das das visuelle Kaschieren in modulfreien Bereichen 920 vorteilhaft, wie in Zusammenhang mit Fig. 4B und Fig. 4C beschrieben, verbessen.

BEZUGSZEICHENLISTE (Teil der Beschreibung)

| | |
|---|---|
| 60 | Außenseite |
| 80 | Innenseite |
| 100, 100', 100", 100‴, 100‴' | Folienverbund |
| 122 | Träger-Laminierfolie |
| 122A | Träger-Laminierfolienstärke |
| 124 | Zwischen-Trägerfolie |
| 124A | Zwischen-Trägerfolienstärke |
| 126 | Zwischen-Deckfolie |
| 126A | Zwischen-Deckfolienstärke |
| 128 | Zwischenlaminat |
| 130, 130', 130", 130‴, 130‴', 130‴″ | Paillette |
| 130A | Paillettenstärke |
| 130.1-4 | erste bis vierte Flächenform einer Paillette |
| 131 | Sichtseite der Paillette |
| 132 | Paillettenkörper |
| 133 | lichtabsorbierende Beschichtung |
| 135 | Prägefolie |
| 136 | Oberflächenstrukturierung |
| 136A | Strukturtiefe der Oberflächenstrukturierung |
| 138 | Mikrospiegelanordnung |
| 140 | lichtabsorbierend beschichtete Paillette |
| 152 | Deck-Laminierfolie |
| 152A | Deck-Laminierfolienstärke |
| 160 | Hintergrund-Laminierfolie |
| 160A | Hintergrund-Laminierfolienstärke |
| 170 | Paillettendeckfolie |
| 170A | Paillettendeckfolienstärke |
| 172, 172', 172" | Paillettenträgerfolie |
| 172A | Paillettenträgerfolienstärke |
| 174 | weitere Paillettenträgerfolie |
| 174A | weitere Paillettenträgerfolienstärke |
| 175 | weitere Paillettendeckfolie |
| 175A | weitere Paillettendeckfolienstärke |
| 176 | haftungsoptimierte Oberfläche |
| 177 | Paillettenklebstoff |
| 177A | Paillettenklebstoffstärke |
| 178 | Fixierklebstoff |
| 178A | Fixierklebstoffstärke |
| 180 | teilreflektierende Beschichtung |
| 180.1-4 | erste bis vierte Beschichtung |
| 180A | Beschichtungsstärke |
| 180.A1-4 | erste bis vierte Beschichtungsstärke |
| 182 | weitere teilreflektierende Beschichtung |

| 184 | veränderliche Beschichtung |
| 186 | lateral variierende Beschichtung |
| 188 | Gradienten-Beschichtung |
| 192 | Dekorfolie |
| 194 | Farbschicht |
| 200 | lichtdurchlässige Scheibe, Deckscheibe |
| 200A | Scheibenstärke |
| 202 | Glasscheibe |
| 220 | Hintergrundscheibe |
| 220A | Hintergrundscheibenstärke |
| 222 | Hintergrund-Glasscheibe |
| 224 | lichtundurchlässige Hintergrund-Deckplatte |
| 300 | Äußere Übergangsschicht |
| 302 | Innere Übergangsschicht |
| 640 | transmissionssenkende Scheibe |
| 640A | Stärke oder Dicke der transmissionssenkenden Scheibe |
| 642 | gefärbtes Glas |
| 644 | Grauglas |
| 700 | Solarmodul |
| 700A | Modulstärke |
| 702 | Moduloberfläche |
| 704 | Modulstrukturen |
| 712 | Photovoltaikmodul |
| 714 | Solarthermiemodul |
| 900 | Gebäudeverkleidungselement |
| 920 | modulfreier Bereich |
| 950, 950', 950", 950''', 950"", 950''''' | Solarglasverbund |
| 951 | Sonnenschutzglasverbund |
| 1000 | Gebäude |
| 1001 | weiteres Gebäude |

| AF | Folienfläche |
| AP | Paillettenfläche |
| B, B1, B2 | Blickrichtung, erste, zweite Blickrichtung |
| DP, DP1, DP2 | Paillettendurchmesser, erster, zweiter Paillettendurchmesser |
| E | Energieausbeute |
| OD | optische Dichte |
| OD2 | weitere optische Dichte |
| PB | Paillettenbreite |
| PL | Paillettenlänge |
| R | reflektierte Lichtstrahlung |
| RE | Reflexionseffekt |
| RE3D | dreidimensionaler Reflexionseffekt |
| S | Lichtstrahlung |
| SP | Paillettenabstand |
| T | transmittierte Lichtstrahlung |
| U | UnterbrechungZF Zwischenfläche |

**Patentansprüche**

1. Folienverbund (100) ausgebildet zur Anordnung in einem Gebäudeverkleidungselement (900) oder einem Solarglasverbund (950), wobei der Folienverbund (100) aufweist:

    - eine Deck-Laminierfolie (152),
    - eine Träger-Laminierfolie (122),
    - eine zwischen der Träger-Laminierfolie (122) und der Deck-Laminierfolie (152) angeordnete Anzahl von Pailletten (130),

**dadurch gekennzeichnet, dass**

- die Paillette (130) eine lichtdurchlässige Paillettenträgerfolie (172) aufweist, die eine teilreflektierende Beschichtung (180) aufweist, derart, dass ein Teil einfallender Lichtstrahlung (S) als transmittierte Lichtstrahlung (T) transmittiert und ein Teil einfallender Lichtstrahlung (S) als reflektierte Lichtstrahlung (R) reflektiert wird, wobei
- die teilreflektierende Beschichtung (180) eine optische Dichte (OD) aufweist, und
- die optische Dichte (OD) zwischen 0,1 und 0,7 liegt, und
- die teilreflektierende Beschichtung (180) der Paillette (130) ausgebildet ist, mittels der reflektierten Lichtstrahlung (R) einen Reflexionseffekt (RE) zu erzeugen, und
- die Pailletten (130) im Folienverbund (100) eine Fläche bedecken, sodass ein Flächenbedeckungsgrad (F) kleiner als 0,7 ist.

2. Folienverbund (100) nach Anspruch 1, **dadurch gekennzeichnet, dass**

- die optische Dichte (OD) zwischen 0,2 und 0,5 liegt, und/oder
- die Pailletten (130) im Folienverbund (100) eine Fläche bedecken, sodass der Flächenbedeckungsgrad (F) kleiner als 0,5 ist, besonders bevorzugt kleiner als 0,3 ist.

3. Folienverbund (100', 100") nach Anspruch 1 oder 2, **gekennzeichnet durch**

- eine zwischen der Träger-Laminierfolie (122) und der Anzahl an Pailletten (130) angeordnete Zwischen-Trägerfolie (124), und/oder
- eine zwischen der Deck-Laminierfolie (152) und der Anzahl an Pailletten (130) angeordnete Zwischen-Deckfolie (126).

4. Folienverbund (100) nach einem der vorherigen Ansprüche, **dadurch gekennzeichnet, dass** eine Träger-Laminierfolienstärke (122A) der Träger-Laminierfolie (122) und/oder eine Deck-Laminierfolienstärke (152A) der Deck-Laminierfolie (152) zwischen 0,2 mm und 3 mm, bevorzugt zwischen 0,35 mm und 1,7 mm, besonders bevorzugt zwischen 0,7 mm und 0,8 mm liegt.

5. Folienverbund (100) nach einem der vorherigen Ansprüche, **dadurch gekennzeichnet, dass**

- mindestens eine Paillette (130) eine weitere Paillettenträgerfolie (174) mit einer weiteren teilreflektierenden Beschichtung (182) auf der zur Sichtseite (131) gerichteten Seite der weiteren Paillettenträgerfolie (174) aufweist.

6. Folienverbund (100) nach einem der vorherigen Ansprüche, **dadurch gekennzeichnet, dass** die teilreflektierende Beschichtung (180) und/oder eine weitere teilreflektierende Beschichtung (182) eine metallische Beschichtung ist, und/oder mindestens eines der folgenden Materialen aufweist, insbesondere aus einem der folgenden Materialen gebildet ist: Chrom, Aluminium, Kupfer, Titannitrid, Aluminium-Kupfer-Legierung, Siliziumdioxid.

7. Folienverbund (100) nach einem der vorherigen Ansprüche, **dadurch gekennzeichnet, dass**

- mindestens eine Paillette (130), insbesondere auf der Paillettenträgerfolie (172) und/oder der weiteren Paillettenträgerfolie (174), eine dreidimensionale Oberflächenstrukturierung (136) aufweist, insbesondere eine Mikrospiegelanordnung (138) aufweist, wobei die dreidimensionale Oberflächenstrukturierung (136) der Mikrospiegelanordnung (138) als Ersatzoptik eine konkave oder eine konvexe Form, ein wellenartiges Muster oder ein Muster wiederkehrender geometrischer Formen ergibt.

8. Folienverbund (100) nach einem der vorherigen Ansprüche, **dadurch gekennzeichnet, dass**

- mindestens eine Paillette (130), insbesondere alle Pailletten (130), als teilreflektierende Beschichtung (180) eine veränderliche Beschichtung (184), bevorzugt eine lateral variierende Beschichtung (186), besonders bevorzugt eine Gradienten-Beschichtung (188), aufweist.

9. Folienverbund (100) nach einem der vorherigen Ansprüche, **dadurch gekennzeichnet, dass** die Träger-Laminierfolie (122) und/oder die Deck-Laminierfolie (152) aus Duroplasten oder Thermoplasten hergestellt ist, insbesondere aus Polyvinyl-Butyral (PVB), Ethylen-Vinylacetat (EVA) oder thermoplastischem Polyurethan (TPU) hergestellt ist.

10. Folienverbund (100) nach einem der vorherigen Ansprüche, **dadurch gekennzeichnet, dass** die Paillettenträgerfolie (172) und/oder die Paillettendeckfolie (170) und/oder eine weitere Paillettenträgerfolie (174) und/oder eine weitere Paillettendeckfolie (175) aus Polyethylenterephthalat (PET), Polymethylmethacrylat (PMMA), Polycarbonat (PC) oder Polyamid (PA) hergestellt ist.

11. Folienverbund (100) nach einem der vorherigen Ansprüche, **gekennzeichnet durch** eine zwischen der Träger-Laminierfolie (122) und der Deck-Laminierfolie (152) angeordnete Anzahl lichtabsorbierend beschichteter Pailletten (140).

12. Folienverbund (100‴, 100‴‴) nach einem der vorherigen Ansprüche, **gekennzeichnet durch** mindestens ein Solarmodul (700) mit einer zum Aufnehmen von Lichtstrahlung (S) ausgebildeten Moduloberfläche (702), insbesondere ein Photovoltaikmodul (712) oder ein Solarthermiemodul (714), insbesondere wobei der Folienverbund (100) in einem modulfreien Bereich (920), in dem kein Solarmodul (700) angeordnet ist, eine Anzahl von lichtundurchlässigen, insbesondere lichtabsorbierend beschichteten, Pailletten (140) aufweist.

13. Folienverbund (100‴) nach Anspruch 12, wobei das mindestens eine Solarmodul (700) ein Photovoltaikmodul (712) ist, **gekennzeichnet durch**

   - eine hinter dem mindestens einen Photovoltaikmodul (712) angeordnete und einer Innenseite (80) zugewandte Hintergrund-Laminierfolie (160), wobei
   - das mindestens eine Photovoltaikmodul (712) zwischen der Träger-Laminierfolie (122) und der Hintergrund-Laminierfolie (160) einlaminiert ist.

14. Gebäudeverkleidungselement (900) aufweisend eine lichtdurchlässige Scheibe (200), insbesondere eine Glasscheibe (202), einen Folienverbund (100) gemäß einem der Ansprüche 1 bis 11 und eine Hintergrundscheibe (220).

15. Solarglasverbund (950), aufweisend eine lichtdurchlässige Scheibe (200) und einen Folienverbund (100) gemäß einem der Ansprüche 1 bis 11 und ein Solarmodul (700) oder einen Folienverbund gemäß Anspruch 12 oder 13 und eine Hintergrundscheibe (220).

**Claims**

1. Film composite (100) configured to be arranged in a building cladding element (900) or a solar glass composite (950), wherein the film composite (100) comprises:

   - a cover laminating film (152),
   - a carrier laminating film (122),
   - a number of spangles (130) arranged between the carrier laminating film (122) and the cover laminating film (152),
   **characterized in that**
   - the spangle (130) has a light-permeable spangle carrier film (172), which has a partially reflective coating (180), such that a portion of the incidental light radiation (S) is transmitted as transmitted light radiation (T) and a portion of the incidental light radiation (S) is reflected as reflected light radiation (R), wherein
   - the partially reflective coating (180) has an optical density (OD), and
   - the optical density (OD) is between 0.1 and 0.7, and
   - the partially reflective coating (180) of the spangle (130) is configured to produce a reflective effect (RE) by means of the reflected light radiation (R), and
   - the spangles (130) in the film composite (100) cover an area such that a degree of area coverage (F) is less than 0.7.

2. Film composite (100) according to claim 1, **characterized in that**

   - the optical density (OD) is between 0.2 and 0.5, and/or
   - the spangles (130) in the film composite (100) cover an area such that the area coverage (F) is less than 0.5, most preferably less than 0.3.

3. Film composite (100', 100") according to claim 1 or 2, **characterized by**

- an intermediate carrier film (124) arranged between the carrier laminating film (122) and the number of spangles (130) and/or
- an intermediate cover film (126) arranged between the cover laminating film (152) and the number of spangles (130).

4. Film composite (100) according to any one of the preceding claims, **characterized in that** a carrier laminating film thickness (122A) of the carrier laminating film (122) and/or a cover laminating film thickness (152A) of the cover laminating film (152) is between 0.2 mm and 3 mm, preferably between 0.35 mm and 1.7 mm, most preferably between 0.7 mm and 0.8 mm.

5. Film composite (100) according to any one of the preceding claims, **characterized in that**

- at least one spangle (130) has a further spangle carrier film (174) with a further partially reflective coating (182) on the side of the further spangle carrier film (174) facing the visible side (131).

6. Film composite (100) according to any one of the preceding claims, **characterized in that** the partially reflective coating (180) and/or a further partially reflective coating (182) is a metallic coating, and/or comprises at least one of the following materials, in particular is formed from one of the following materials: chromium, aluminum, copper, titanium nitride, aluminum-copper alloy, silicon dioxide.

7. Film composite (100) according to any one of the preceding claims, **characterized in that**

- at least one spangle (130), in particular on the spangle carrier film (172) and/or the further spangle carrier film (174), has a three-dimensional surface structuring (136), in particular a micromirror arrangement (138), wherein the three-dimensional surface structuring (136) of the micromirror arrangement (138) produces a concave or convex shape, a wave-like pattern or a pattern of recurring geometric shapes as a substitute optic.

8. Film composite (100) according to any one of the preceding claims, **characterized in that**

- at least one spangle (130), in particular all spangles (130), has a variable coating (184), preferably a laterally varying coating (186), most preferably a gradient coating (188), as a partially reflective coating (180).

9. Film composite (100) according to any one of the preceding claims, **characterized in that** the carrier laminating film (122) and/or the cover laminating film (152) is made from thermosetting plastics or thermoplastics, in particular polyvinyl butyral (PVB), ethylene vinyl acetate (EVA) or thermoplastic polyurethane (TPU).

10. Film composite (100) according to any one of the preceding claims, **characterized in that** the spangle carrier film (172) and/or the spangle cover film (170) and/or a further spangle carrier film (174) and/or a further spangle cover film (175) is produced from polyethylene terephthalate (PET), polymethyl methacrylate (PMMA), polycarbonate (PC) or polyamide (PA).

11. Film composite (100) according to any one of the preceding claims, **characterized by** a number of light-absorbing coated spangles (140) arranged between the carrier laminating film (122) and the cover laminating film (152).

12. Film composite (100''', 100'''') according to any one of the preceding claims, **characterized by** at least one solar module (700) with a module surface (702) designed to absorb light radiation (S), in particular a photovoltaic module (712) or a solar thermal module (714), in particular wherein the film composite (100) has a number of light-impermeable, in particular light-absorbing coated spangles (140) in a module-free region (920) in which no solar module (700) is arranged.

13. Film composite (100''') according to claim 12, wherein the at least one solar module (700) is a photovoltaic module (712), **characterized by**

- a background laminating film (160) arranged behind the at least one photovoltaic module (712) and facing an inner side (80), wherein
- the at least one photovoltaic module (712) is laminated between the carrier laminating film (122) and the background laminating film (160).

**14.** Building cladding element (900) comprising a light-permeable pane (200), in particular a glass pane (202), a film composite (100) according to any one of claims 1 to 11 and a background pane (220).

**15.** Solar glass composite (950), comprising a light-permeable pane (200) and a film composite (100) according to any one of claims 1 to 11 and a solar module (700) or a film composite according to claim 12 or 13 and a background pane (220).

**Revendications**

**1.** Film composite (100) conçu pour être disposé dans un élément de revêtement de bâtiment (900) ou un composite de verre solaire (950), le film composite (100) comportant:

- un film de stratification de couverture (152),
- un film de stratification de support (122),
- un certain nombre de paillettes (130) disposées entre le film de stratification de support (122) et le film de stratification de couverture (152),
**caractérisé en ce que**
- la paillette (130) comporte un film de support translucide (172) qui possède un revêtement partiellement réfléchissant (180), de telle sorte qu'une partie du rayonnement lumineux incident (S) est transmise sous forme de rayonnement lumineux transmis (T) et une partie du rayonnement lumineux incident (S) est réfléchie sous la forme d'un rayonnement lumineux réfléchi (R), où
- le revêtement partiellement réfléchissant (180) présente une densité optique (OD), et
- la densité optique (OD) est comprise entre 0,1 et 0,7, et
- le revêtement partiellement réfléchissant (180) de la paillette (130) est conçu pour produire un effet de réflexion (RE) au moyen du rayonnement lumineux réfléchi (R), et
- les paillettes (130) dans le film composite (100) couvrent une zone de telle sorte qu'un degré de couverture de zone (F) est inférieur à 0,7.

**2.** Film composite (100) selon la revendication 1, **caractérisé en ce que**

- la densité optique (OD) est comprise entre 0,2 et 0,5, et/ou
- les paillettes (130) dans le film composite (100) couvrent une zone, de sorte que le degré de couverture de zone (F) soit inférieur à 0,5, de manière particulièrement préférée inférieur à 0,3.

**3.** Film composite (100', 100") selon la revendication 1 ou 2, **caractérisé par**

- un film de support intermédiaire (124) disposé entre le film de stratification de support (122) et le certain nombre de paillettes (130), et/ou
- un film de couverture intermédiaire (126) disposé entre le film de stratification de couverture (152) et le certain nombre de paillettes (130).

**4.** Film composite (100) selon l'une des revendications précédentes, **caractérisé en ce qu'**une épaisseur de film de stratification de support (122A) du film de stratification de support (122) et/ou une épaisseur de film de stratification de couverture (152A) du film de stratification de couverture (152) est située entre 0,2 mm et 3 mm, de préférence entre 0,35 mm et 1,7 mm, de manière particulièrement préférée entre 0,7 mm et 0,8 mm.

**5.** Film composite (100) selon l'une des revendications précédentes, **caractérisé en ce que**

- au moins une paillette (130) présente un autre film de support de paillette (174) avec un autre revêtement partiellement réfléchissant (182) sur le côté de l'autre film de support de paillette (174) faisant face au côté visible (131).

**6.** Film composite (100) selon l'une des revendications précédentes, **caractérisé en ce que** le revêtement partiellement réfléchissant (180) et/ou un autre revêtement partiellement réfléchissant (182) est un revêtement métallique, et/ou présente au moins l'un des matériaux suivants, notamment est constitués de l'un des matériaux suivants : chrome, aluminium, cuivre, nitrure de titane, alliage aluminium-cuivre, dioxyde de silicium.

**7.** Film composite (100) selon l'une des revendications précédentes, **caractérisé en ce que**

- au moins une paillette (130), en particulier sur le film de support de paillette (172) et/ou l'autre film de support de paillette (174), présente une structuration de surface tridimensionnelle (136), en particulier un agencement de micromiroirs (138), dans lequel la structuration de surface tridimensionnelle (136) de l'agencement de micromiroirs (138) en tant qu'optique de remplacement produit une forme concave ou convexe, un motif ondulé ou un motif de formes géométriques récurrentes.

**8.** Film composite (100) selon l'une des revendications précédentes, **caractérisé en ce que**

- au moins une paillette (130), en particulier toutes les paillettes (130), présente un revêtement variable (184), de préférence un revêtement variable latéralement (186), de manière particulièrement préférée un revêtement dégradé (188), en tant que revêtement partiellement réfléchissant (180).

**9.** Film composite (100) selon l'une des revendications précédentes, **caractérisé en ce que** le film de stratification de support (122) et/ou le film de stratification de couverture (152) est réalisé à partir de thermodurcissables ou de thermoplastiques, notamment à partir de polyvinylbutyral (PVB), éthylène-acétate de vinyle (EVA) ou poly-uréthane thermoplastique (TPU).

**10.** Film composite (100) selon l'une des revendications précédentes, **caractérisé en ce que** le film de support de paillette (172) et/ou le film de recouvrement de paillette (170) et/ou un autre film de support de paillette (174) et/ou un autre film de recouvrement de paillette (175) est réalisé en polyéthylène téréphtalate (PET), polyméthac-rylate de méthyle (PMMA), polycarbonate (PC), ou polyamide (PA).

**11.** Film composite (100) selon l'une des revendications précédentes, **caractérisé par** un certain nombre de paillettes revêtues absorbant la lumière (140) disposées entre le film de stratification de support (122) et le film de stratification de couverture (152).

**12.** Film composite (100‴, 100⁗) selon l'une des revendications précédentes, **caractérisé par** au moins un module solaire (700) avec une surface de module (702) conçue pour absorber un rayonnement lumineux (S), notamment un module photovoltaïque (712) ou un module solaire thermique (714), en particulier dans lequel le film composite (100) présente un certain nombre de paillettes (140) opaques, en particulier recouvertes d'un revêtement absorbant la lumière, dans une zone sans module (920) dans lequel aucun module solaire (700) n'est disposé.

**13.** Film composite (100‴) selon la revendication 12, dans lequel le au moins un module solaire (700) est un module photovoltaïque (712), **caractérisé par**

- un film de stratification de fond (160) disposé derrière ledit au moins un module photovoltaïque (712) et faisant face à un côté interne (80), dans lequel
- le ou les modules photovoltaïques (712) sont stratifiés entre le film de stratification de support (122) et le film de stratification de fond (160).

**14.** Elément de bardage de bâtiment (900) comprenant une vitre translucide (200), notamment une vitre en verre (202), un film composite (100) selon l'une des revendications 1 à 11 et une plaque de fond (220).

**15.** Verre solaire composite (950), comprenant une vitre translucide (200) et un film composite (100) selon l'une des revendications 1 à 11 et un module solaire (700) ou un film composite selon la revendication 12 ou 13 et une plaque de fond (220).

Fig. 1A

Fig. 1B

Fig. 1C

EP 4 179 578 B1

Fig. 2

Fig. 3A

Fig. 3B

EP 4 179 578 B1

Fig. 4A

Fig. 4B

Fig. 4C

EP 4 179 578 B1

Fig. 5

Fig. 6A

Fig. 6B

Fig. 6C

Fig. 6D

Fig. 6E

EP 4 179 578 B1

EP 4 179 578 B1

130""

176    131  177, 177A
136A        170  180    60        170A
                                         130A
136, 138
178, 178A        172              172A
                      80

## Fig. 6F

140

            177, 177A
176  170  131  133    60        170A
180                              140A
178, 178A        172"            172A
                      80

## Fig. 6G

Fig. 7C

Fig. 7B

Fig. 7A

Fig. 7F

Fig. 7E

Fig. 7D

130, 130.1

DP

Fig. 8A

130, 130.2

PB

PL

Fig. 8B

130, 130.3

PB

PL

Fig. 8C

130, 130.4

PB

PL

Fig. 8D

Fig. 8E

130, 130.5

PB

PL

Fig. 8F

130, 130.5'

PB

PL1    U    PL2

Fig. 8G

100

130, 130.5

130, 130.5

U

U

Fig. 8H

180, 184, 186, 188

130

180, 180A

EP 4 179 578 B1

FIG. 9

EP 4 179 578 B1

Fig.10

EP 4 179 578 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9281186 B2
- WO 2013040617 A1
- WO 2019038288 A1
- WO 2019057327 A1